# EUROPÄISCHE PATENTSCHRIFT

(11) **EP 2 796 017 B1**
(45) Veröffentlichungstag und Bekanntmachung des Hinweises auf die Patenterteilung: **19.10.2016**
(21) Anmeldenummer: 12815991.0
(22) Anmeldetag: 06.12.2012
(51) Int. Cl.: H05K 3/40, B21D 39/03, H01R 43/048, H05K 1/02, H05K 3/20, H01R 4/06, H01R 4/18

(54) **VERFAHREN ZUR HERSTELLUNG EINER ELEKTRISCHEN HOCHFREQUENZ-VERBINDUNG ZWISCHEN ZWEI PLATTENFÖRMIGEN LEITERBAHNABSCHNITTEN SOWIE EINE ZUGEHÖRIGE ELEKTRISCHE HOCHFREQUENZ-VERBINDUNG**
METHOD FOR PRODUCING AN ELECTRICAL RADIOFREQUENCY CONNECTION BETWEEN TWO PLATE-SHAPED CONDUCTOR TRACK SECTIONS AND AN ASSOCIATED ELECTRICAL RADIOFREQUENCY CONNECTION
PROCÉDÉ DE RÉALISATION D'UNE LIAISON ÉLECTRIQUE HAUTE-FRÉQUENCE ENTRE DEUX SEGMENTS CONDUCTEURS EN FORME DE PLAQUES AINSI QU'UNE LIAISON ÉLECTRIQUE HAUTE-FRÉQUENCE ASSOCIÉE

(30) Priorität: 22.12.2011 DE 102011122037
(43) Veröffentlichungstag der Anmeldung: 29.10.2014
(73) Patentinhaber: Kathrein-Werke KG, 83022 Rosenheim (DE)
(72) Erfinder: FRÖHLER, Christian, 83128 Halfing (DE); GÜNTHER, Mario, 83059 Kolbermoor (DE)
(74) Vertreter: Flach, Dieter Rolf Paul
(86) Internationale Anmeldenummer: PCT/EP2012/005036
(87) Internationale Veröffentlichungsnummer: WO 2013/091784

(56) Entgegenhaltungen:
- DE-A1- 10 205 521
- DE-A1- 10 248 020
- DE-A1- 19 929 778
- US-B1- 6 243 946

## Beschreibung

In der Elektrotechnik allgemein und in der Mobilfunktechnik im Besonderen, vor allem beim Bau von Antennenanlagen für Basisstationen in der Mobilfunktechnik müssen häufig elektrisch leitfähige Bahnen und Abschnitte elektrisch miteinander verbunden werden.

So ist beispielsweise aus der DE 10 2005 047 975 A1 bzw. der US 7,358,924 B2 bekannt, dass vor einem Reflektorblech einer Mobilfunkantenne eine Vielzahl von streifenförmigen aus einem Metallblech gefertigten Leitungsbahnen verwendet werden, die miteinander elektrisch verbunden bzw. gekoppelt werden müssen. Gemäß der vorstehenden Vorveröffentlichung ist dabei aus verschiedenen Gründen vorgeschlagen worden zwei aus einem Metallstreifen bestehende Leiterbahnen kapazitiv zu koppeln.

Grundsätzlich könnten abgesehen von einer kapazitiven Kopplung eine Vielzahl bekannter elektrischer Verbindungstechniken zum Einsatz kommen, beispielsweise dadurch, dass zwei elektrisch leitfähige Metallstreifen miteinander verschweißt oder verlötet werden. Möglich wäre grundsätzlich auch, dass zwei elektrisch zu verbindende Metallplatten oder streifenförmige metallische Leiterplatten miteinander verschraubt oder vernietet werden. Dabei kann eine Kontaktfläche durch Verformung ausgebildet sein.

Dabei ist es stets Aufgabe und Ziel bei derartiger Anwendung in der Regel eine dauerhafte elektrische und mechanische Verbindung sicher zu stellen, die von der Qualität her den höchsten Anforderungen genügt, eine hohe Reproduzierbarkeit und Prozessüberwachung erlaubt und vor allem auch eine zerstörungsfreie Prüfung. Dabei soll die angewandte Verbindungstechnik eine hohe Lebensdauer aufweisen und wenn möglich keiner Korrosion oder nur einer geringsten Korrosion und Alterung unterliegen.

Neben der Wirtschaftlichkeit und der Prozesssicherheit soll auch eine hohe Fertigungskompatibilität realisiert werden, unter anderem soll die Verbindungstechnik geringe Toleranzen aufweisen, einen geringen Verzug und auch wenn möglich nachfolgende Fertigungsschritte noch erlauben.

Darüber hinaus bestehen aber in der Elektrotechnik allgemein und in der Hochfrequenztechnik im Besonderen und somit also auch vor allem auf dem Gebiet der Mobilfunktechnik das Problem, dass die jeweils angewandte Verbindungstechnik zudem gewährleisten muss, dass keine Intermodulationen auftreten, auch nicht durch Toleranz- oder Korrosionsprobleme bedingt. Ferner soll das so genannte Stehwellenverhältnis, nämlich das so genannte "Voltage Standing Wave Ratio (VSWR)" möglichst gering sein, also auf der betreffenden Leitung ein einen möglichst geringen oder am besten gar keinen Reflektionsgrad aufweisen, also gegen 0 gehen, wenn eine Leitung ideal abgeschlossen ist.

Dabei soll auch darauf hingewiesen werden, dass im Mobilfunkbereich an der Basisstation ein relativ hoher Sendepegel zum einen und demgegenüber ein sehr niedriger Empfangspegel zum anderen vorliegt. Der sehr niedrige Empfangspegel ist bedingt durch die relativ niedrige Sendeleistung des Mobilgeräts, die noch durch die Luftstrecke gedämpft wird. Der Empfänger der Basisstation erhält also nur eine sehr geringe Eingangsleistung. Damit bei zwei Sendesignalen (mit hohem Signalpegel) der Empfänger nicht gestört wird, müssen die im gemeinsamen Antennenpfad erzeugten (passiven) Intermodulationsprodukte zum Beispiel um 140 dB niedriger sein, als der Sendepegel. Bei dieser hohen Anforderung machen sich bereits Effekte wie mikroskopische Wackelkontaktstellen oder Materialverunreinigungen bemerkbar.

Vor diesem Hintergrund stellt sich die Frage einer geeigneten Hochfrequenz-Verbindungstechnik.

Es sind die unterschiedlichsten elektrischen Verbindungsarten bekannt. So wird zum Beispiel in der DE 102 05 521 A1 beschrieben, dass beispielsweise zwei Metallstrukturen im Bereich von nockenförmigen Vorsprüngen miteinander elektrisch kontaktiert werden können, bei denen also zumindest eine der beiden Metallstrukturen eine herausragende, der jeweils anderen Metallstruktur zugewandten Kontaktzone aufweist. Dabei soll zwischen den Metallstrukturen eine elektrisch isolierende Schicht angeordnet sein. Die erwähnte elektrische Kontaktierung soll dabei durch geeignete Maßnahmen wie Schweißen, Löten, Druckcrimpen, Nieten, Bonden, Sintern, Reaktionsschweißen oder Reaktionsfügen hergestellt werden.

Ergänzend dazu ist beispielsweise aus der EP 1 045 201 A1 ein Beispiel für eine Befestigung eines elektrischen Bauteils an einer Leuchte als bekannt zu entnehmen. Dazu umfasst das elektrische Bauteil einen metallischen Grundkörper, ebenso wie die Leuchte. Beide metallischen Grundkörper werden in Parallellage zueinander gebracht, um dann das elektrische Bauteil an einer oder mehreren geeigneten Stellen seines Blechgehäuses, vorzugsweise im Bereich der Tragplatte durch Schweißen, Scheren, Druckfügen oder in sonstiger Weise elektrisch leitend mit dem Montageblech der Leuchte zu verbinden.

Ein dazu ähnliches Verfahren ist beispielsweise auch aus der DE 10 2007 032 142 A1 als bekannt zu entnehmen. Beschrieben wird ein Elektronikmodul sowie ein Verfahren zu dessen Herstellung. Das Elektronikmodul weist dazu ein erstes und zweites Substrat auf, das als Spritzgussgehäuse oder Spritzpressgehäuse gebildet ist. Das Substrat weist ferner Anschlüsse auf, die als Stanzgitter ausgebildet sind. Auch die Anschlüsse des zweiten Substrats sind als Stanzgitter ausgebildet, wobei dann beide Stanzgitter an zumindest einer Stelle miteinander direkt verbunden werden. Die in diesem Bereich vollflächig aufeinanderliegenden elektrisch leitfähigen Bleche werden an den zu verbindenden Stellen, beispielsweise mittels einer Schweiß-, Tox- und/oder einer Klemmverbindung miteinander elektrisch verbunden.

Als weiteres Beispiel einer derartigen Verbindungsart wird auf die Vorveröffentlichung DE 299 12 797 U1 verwiesen. Darin wird eine elektronische Baueinheit mit einer elektrisch leitenden Sammelschiene beschrieben, an welcher zumindest eine Kontaktlasche eines elektrischen Betriebsmittels angeschlossen werden soll. Die Verbindung soll dabei mittels mechanischen Druckfügens mittels einer abgestimmten Stempel-Matritzen-Kombination erzeugt werden. Dadurch können die beiden aufeinanderliegenden Platten oder Leiterbahnen über die Fügeverbindung hinaus vollflächig aufeinanderliegend miteinander verbunden werden.

Es handelt sich bei derartigen Verbindungstechniken üblicherweise um die elektrische Kontaktierung an Masse oder an einem anderen Potenzial.

Wie zwei Metallbleche mit einer zwischenliegenden Kunststoffplatte mittels eines Durchsetz-Fügeverfahrens zur Herstellung einer rein mechanischen Verbindung miteinander verbunden werden können, ist grundsätzlich auch aus der DE 199 29 377 A1 als bekannt zu entnehmen. Das hierin beschriebene Verfahren dient allerdings lediglich zur Herstellung einer mechanischen und nicht zur Herstellung einer elektrischen Verbindung, insbesondere auch deshalb, da in dieser Vorveröffentlichung davon ausgegangen wird, dass während der Herstellung einer Durchsetz-Fügeverbindung die zwischen den beiden Metallblechen befindliche Kunststoffplatte reißen oder nicht reißen kann, was zur Herstellung einer mechanischen Verbindung allerdings ohne jede Bedeutung ist.

Aus der US 6,243,946 B1 ist als bekannt zu entnehmen, eine Zwischenschicht-Verbindungsstruktur herzustellen, bei der eine flexible Isolierschicht aus thermoplastischem Kunststoffmaterial zwischen zwei Kupferfolien gelegt wird. Mittels eines Werkzeuges in Form von mit Vorsprüngen versehenen Restplatten können dann Verjüngungen in dem drei Lagen umfassenden Schichtmaterial hergestellt werden. Es handelt sich somit um eine spezifisch bearbeitete Leiterplatte. Bei derartigen Pressverformungen werden keine Fügewerkzeuge eingesetzt, wie sie beispielsweise zur Herstellung einer mechanischen Verbindung zwischen zwei Teilblechen in einer dazwischenliegenden Kunststoffplatte im Zusammenhang mit dem vorstehend erwähnten DE 199 29 377 A1 beschrieben wurden.

Dort ist beispielsweise beschrieben, dass zwei Metallstrukturen kontaktiert werden sollen, wobei mindestens eine der Metallstrukturen auf ihrer der zweiten Metallstruktur zugewandt liegenden Seite eine aus der Ebene der Metallstruktur herausragenden Kontaktzone aufweist. Dabei soll zwischen den Metallstrukturen eine elektrisch isolierende Schicht angeordnet sein, wobei eine Metallstruktur mit der elektrisch isolierenden Schicht ebenfalls laminiert wird, wobei während des Laminierens der zweiten Metallstruktur mit der elektrisch isolierenden Schicht eine elektrische Kontaktierung zwischen den beiden Metallstrukturen erfolgen soll. Diese elektrische Kontaktierung soll durch geeignete Maßnahmen wie Schweißen, Löten, Druckcrimpen, Nieten, Bonden, Sintern, Reaktionsschweißen oder Reaktionsfügen hergestellt werden.

Aus der DE 102 78 020 A1 sind ein Verfahren und eine Vorrichtung zum Fügen von zumindest zwei Bauteilen als bekannt zu entnehmen. Mittels einer Fügeverbindung werden zwei parallel zueinander verlaufende elektrisch leitende Schichten mit einer dazwischen befindlichen Isolierschicht mittels eines Durchsetzwerkzeuges unter Herstellung einer Fügeverbindung miteinander verbunden.

Aus den vorstehenden Erläuterungen geht bereits hervor, dass die unterschiedlichsten elektrischen Verbindungsarten bekannt sind, häufig in Form von Löten, beispielsweise auch in Form von Schweißen. Dies ist z.B. aus der DE 102 05 521 A1 zu entnehmen.

Aufgabe der vorliegenden Erfindung ist es, eine verbesserte elektrische Verbindung zwischen zumindest zwei oder mehreren metallischen plattenförmigen Leiterbahnabschnitten zu schaffen, die möglichst einfach herstellbar ist, wobei die erläuterte Verbindung in mechanischer und vor allem elektrischer Hinsicht dauerhaft und problemfrei in der Hochfrequenz-Technik eingesetzt werden kann und soll, um vor allem hier die Gefahr des Auftretens von Intermodulationen oder einem schlechten VSWR-Verhältnis so gering als möglich zu halten.

Die Aufgabe wird bezüglich des Verfahrens entsprechend den im Anspruch 1 oder 4 und bezüglich einer entsprechend hergestellten elektrischen Verbindung entsprechend den im Anspruch 11 oder 14 angegebenen Merkmalen gelöst. Vorteilhafte Ausgestaltungen der Erfindung sind in den Unteransprüchen angegeben.

Im Rahmen der Erfindung lässt sich also sowohl eine galvanische sowie eine kapazitive Verbindung zwischen zwei Plattenabschnitten in vorteilhafter Weise realisieren. Eine galvanische Verbindung zwischen zwei Plattenabschnitten kann dadurch hergestellt werden, dass zumindest in dem Bereich außerhalb der Fügeverbindung, also in dem Bereich wo die Platten in der Regel unverformt bleiben, eine z.B. die beiden Platten auf Abstand haltende Folie oder Folienschicht dazwischen angeordnet ist, insbesondere eine isolierende Folienschicht. Diese weist bevorzugt im Bereich der Fügeverbindung eine Ausnehmung (Loch) auf, um hier die beiden Platten wie gewünscht galvanisch zu verbinden. Insbesondere in diesem Falle kann auf die oben erläuterte Vorprägung unter Ausbildung eines umlaufenden Wulstes verzichtet werden, worüber die Platten im Abstand zueinander positioniert werden können (um dann in einem weiteren oder anschließenden Schritt die Fügeverbindung durchzuführen).

Mit anderen Worten kann also die Folie im Bereich der Fügeverbindung eine lochförmige Ausnehmung aufweisen. Dann können die bevorzugt parallel zueinander verlaufenden Platten im Rahmen der Erfindung entsprechend durch die Fügeverbindung verbunden werden, wobei in diesem zuvor genannten Falle es nicht mehr zwingend notwendig ist zuvor in zumindest einer der beiden zu verbindenden Platten eine topfförmige Vertiefung einzubringen, um hier die Platten vor der weiteren Verarbeitung in Anlage zueinander zu halten.

Ebenso kann eine kapazitive elektrische Verbindung dadurch hergestellt werden, dass die beiden zu verbindenden elektrischen Platten unter Zwischenschaltung einer isolierenden Folie oder Folienschicht aufeinander gelegt und dann in einem Verbindungsbereich die Fügeverbindung im geschilderten Maße hergestellt wird. Dabei hält die isolierende Folienschicht auch im Verbindungsbereich der Fügeverbindung die beiden Plattenabschnitte im Abstand zueinander um vor allem hier die kapazitive Kopplung zu ermöglichen. Diese weist insbesondere in der Hochfrequenztechnik große Vorteile auf.

Die erfindungsgemäße Lösung lässt sich also vorteilhaft dadurch umsetzen, dass zwischen den zu verbindenden plattenförmigen Elementen dazwischenliegend eine Folie sandwichartig eingefügt ist. Dann wird an der bevorzugten Verbindungsstelle eine kapazitive Kopplung realisiert. Dabei kann die ansonsten zwischen den beiden plattenförmigen Elementen verlaufende elektrisch nicht leitfähige Folie dicker ausgebildet sein, mit anderen Worten also im Bereich der Fügeverbindung durch die Materialdehnung dünner werden, wodurch sich eine gewünschte Kapazität einstellen lässt.

Auch wenn vorstehend wie nachfolgend teilweise von einer Folie oder einer isolierenden Folie oder einer Folienschicht gesprochen wird, muss es sich dabei nicht zwangsweise um eine Folie handeln, auch nicht um eine separate zwischen den Platten zu positionierende Folienschicht. Genauso möglich ist es eine Platte, d.h. insbesondere eine isolierende Platte zu verwenden, die mitverformt wird. Die isolierende Schicht kann nicht nur als separate isolierende Platte oder Folienschicht vorgesehen sein, sondern beispielsweise auch in Form einer Beschichtung, Lackierung, Pulverbeschichtung, aufgewalzten Schicht etc., die an zumindest einer Oberfläche der beiden zu verbindenden Platten ausgebildet ist. Mit anderen Worten sind dadurch beide zu verbindenden Platten durch die an zumindest einer Oberfläche der zumindest beiden zu verbindenden Platten ausgebildeten isolierenden Schicht galvanisch voneinander getrennt, um die kapazitive Kopplung mit dem Durchsetz-Fügeverfahren zu realisieren.

Im Rahmen der Erfindung ist es möglich, zwei elektrisch leitfähige Platten, beispielsweise zwei Metall- oder Legierungsstreifen, mechanisch dauerhaft fest miteinander zu verbinden, wobei diese Verbindung höchsten Kraftbeanspruchungen dauerhaft Stand hält. Überraschend ist dabei, dass es im Rahmen der angewandten Verbindungstechnik auf dem Gebiet der Hochfrequenztechnik im Allgemeinen und der Mobilfunktechnik im Besonderen nunmehr möglich ist, zudem die Verbindung als gute elektrische Verbindung zwischen zumindest zwei elektrisch leitfähigen plattenförmigen Körpern auszugestalten, ohne dass Intermodulationen auftreten und ohne dass das VSWR-Verhältnis gegenüber anderen Verbindungstechniken verschlechtert wird. Im Gegenteil dazu kann sogar festgestellt werden, dass gegenüber herkömmlichen Verbindungstechniken die im Rahmen der Erfindung zumindest beiden elektrisch leitfähigen Platten mechanisch dauerhafer und fester bei verbesserten Intermodulations- und VSWR-Verhältnissen verbunden werden können.

Im Rahmen des erfindungsgemäßen Verfahrens werden dabei die zumindest beiden Platten gemäß der an sich bekannten Technik des Durchsetzfügens (Toxen) miteinander verbunden, bei der beispielsweise zwei Bleche mit einem längsverschiebbaren Stempel und einer gegenüber dem Stempelgehäuse fest angeordneten Matrize mit einer entsprechenden Tiefziehöffnung miteinander verbunden werden. Durch das Einfahren des Stempels in die Matrizenteile werden die entsprechenden plattenförmigen Abschnitte der zu verbindenden Platten so miteinander verformt, dass die auf der Stempelseite oben liegende Platte in darunter befindliche Abschnitte der darunter befindlichen Platte eingreift und zwar in hinterschneidenden Abschnitten, so dass eine optimale mechanische feste Verbindung realisiert wird.

Eine derartige Verbindungstechnik wäre aber auf dem Gebiet der Hochfrequenztechnik ungeeignet, da die elektrisch leitfähigen Platten über die Befestigungsstelle hinaus elektrisch kontaktiert werden und damit nicht eindeutig reproduzierbare und zudem Schwankungen unterliegenden Kontakte aufweisen würden, wodurch beachtliche Intermodulations-Probleme entstehen würden. Dadurch würde sich auch das Stehwellenverhältnis drastisch verschlechtern.

Im Rahmen der Erfindung ist dabei bevorzugt vorgesehen, dass das obere Blech, d.h. die obere Platte vor dem Durchsetzfügen oder gleichzeitig dazu einer Prägung unterworfen, d.h. unterzogen wird, bei der die obere Platte zunächst eine topf- oder pfannenähnliche Ausbauchung gegenüber der darunter befindlichen zweiten Platte erfährt.

Bevorzugt anschließend kann im Rahmen der Erfindung das Durchsetzfügen durchgeführt werden, ähnlich wie im Stand der Technik auch. Wie im Stand der Technik werden die dadurch verformten Materialabschnitte der beiden Platten durch den hohen Druck und die dadurch bewirkte Fließfähigkeit des Materials verformt, und zwar in eine hintergreifende Weise, wodurch in bekannter Weise die mechanische Verbindung realisiert wird.

Die erfindungsgemäße Verbindungstechnik zeichnet sich vor allem dadurch aus, dass die Verbindung zweier elektrisch leitfähiger Plattenabschnitte nicht nur extrem fest und mechanisch stabil ist sondern vor allem für die galvanische Verbindung wie sich gezeigt hat höchst geeignet ist, da vor allem auch keine unerwünschten Intermodulationen auftreten.

Insbesondere dann, wenn zunächst die erwähnte Vorprägung mit einer topf-, schalen-, teller- oder pfannenförmigen Vertiefung der ersten oder zweiten Platte durchgeführt wird, entsteht dadurch ein umlaufender Wulst oder Ringwulst, der dafür sorgt, dass die eine Platte gegenüber der anderen Platte durch den wulstförmigen Verbindungsbereich auf Abstand gehalten wird. Um dann in einem fortlaufenden weiteren oder separaten zweiten Verfahrensschritt die eigentliche Fügeverbindung herzustellen.

Mit anderen Worten wird die mechanische und damit die elektrische Verbindung im Wesentlichen nur in dem Bereich der zu verbindenden Metallplatten oder Metallstreifen etc. realisiert, der verformt wird, also einschließlich jenes Bereiches, der beispielsweise im Rahmen der Umformung einen umlaufenden tellerförmigen Wulst erhalten hat.

Ein Verfahren zum Herstellen eines Elektro-Installationsgerätes ist dabei grundsätzlich auch aus der DE 44 31 274 C2 bekannt geworden. Diese Vorveröffentlichung beschreibt den Einbau einer Kontaktbrücke, bei der das zugehörige Brückenelement sowie Kontaktelemente zunächst als gesonderte Teile vorgefertigt werden. Diese gesonderten Teile sollen dann jeweils in eine entsprechende Aufnahme des Gehäuseteils des Gerätes einzeln eingesetzt werden, damit sie dann jeweils mit ihren Verbindungsbereichen lose aufeinander liegen. In dem so eingesetzten und in einer Aufnahme fixierten Zustand werden die Teile dann jeweils in den Verbindungsbereichen im Durchsetz-Fügeverfahren unmittelbar formschlüssig miteinander verbunden. Hierzu werden eine Matrize und ein Rundstempel auf der Fügeachse gegeneinander bewegt, wodurch die Blech-Verbindungsbereiche derart in eine Öffnung der Matrize gepresst werden sollen, dass durch Hinterfließen eine direkte formschlüssige Verbindung entsteht. Es handelt sich hierbei also um ein spezielles Verfahren zum Herstellen eines Elektro-Installationsgerätes, wohingegen im Rahmen der vorliegenden Erfindung allgemein eine elektrisch-galvanische oder elektrisch-kapazitive Verbindung zwischen zwei plattenförmigen Teilen realisiert werden soll, die insbesondere auch in der Hochfrequenztechnik eingesetzt werden sollen, insbesondere nämlich im Mobilfunkbereich. Alle für den Mobilfunkbereich geeigneten Hochfrequenzen kommen dabei im Rahmen der Erfindung insbesondere in Betracht, ohne hierauf eingeschränkt zu sein.

Bekanntermaßen kann beim Durchsetz-Fügeverfahren die verwendete Matrize mit einer am Übergang vom Matrizenboden zur Matrizenwand umlaufend versehenen Sicke oder Rinne ausgestattet sein, wodurch mehr Material der unteren Platte in diesen Bereich hinein fließen kann, wodurch in bekannter Weise sicher gestellt wird, dass das Material der oberen Platte entsprechende entstehende Hinterschneidungen im Bereich der unteren Platte hintergreift und damit zur verbesserten Verbindungstechnik beiträgt.

Vorzugsweise wird im Rahmen der Erfindung auch ein angepasster Abstreifer oder so genannte Niederhalter verwendet, der beim Zurückziehen des Stempels sicher stellt, dass die durch das Fügeverfahren verbundenen Platten benachbart zu der jeweiligen Verbindungsstelle bei seinem Verbindungsbereich im Abstand zueinander gehalten werden ohne unerwünschten Verformungen zu unterliegen.

Durch die Art der Verbindungstechnik könnten theoretisch aber auch mehr als zwei derartiger Platten verbunden werden, wie dies beispielsweise grundsätzlich aus der WO 01/00347 A2 bekannt ist. Dort werden im Durchsetz-Fügeverfahren beispielsweise drei Platten miteinander verbunden, nämlich zwei parallel zueinander angeordnete Metallplatten und eine dazwischen angeordnete Kunststoffplatte.

Die Erfindung wird nachfolgend anhand von Zeichnungen für einzelne Beispiele der Erfindung näher erläutert. Dabei zeigen im Einzelnen:
- Figur 1:: eine schematische räumliche ausschnittsweise Darstellung zweier zu verbindender Platten;
- Figur 2:: eine schematische Querschnittsdarstellung durch zwei zu verbindende Platten, die in Parallellage zueinander angeordnet sind, wobei die obere Platte bereits an der herzustellenden Verbindungsstelle (Verbindungsbereich) eine Auswölbung in Richtung der darunter befindlichen zweiten Platte in einem ersten Verfahrensschritt erhalten hat;
- Figur 3:: eine entsprechende Querschnittsdarstellung der in Figur 1 und 2 gezeigten und dort noch nicht verbundenen Platten, die gemäß der Darstellung nach Figur 3 in ihrem Verbindungsbereich mittels Durchsetzfügens verbunden sind, wobei dieses Beispiel nicht zur Erfindung gehört;
- Figur 4:: ein zu Figur 3 leicht abgewandeltes, nicht zur Erfindung gehörendes Ausführungsbeispiel im Querschnitt;
- Figur 5:: eine schematische Querschnittsdarstellung durch die beiden zu verbindenden elektrisch leitfähigen Platten (ohne Darstellung einer zwischen den Platten vorgesehenen Isolierfolie) in einem entsprechenden Werkzeug mit oben liegenden Pressstempel und unten angeordneter Matrize;
- Figur 6:: ein zu Figur 5 abgewandeltes Beispiel unter Verdeutlichung, wie mit einem Durchsetzfügewerkzeug gleichzeitig zwei Durchsetzfügeverbindungen benachbart zueinander hergestellt werden könnten;
- Figur 6a:: eine räumliche teilweise im Schnitt wiedergegebene Darstellung bezüglich zweier verbundener Metallstreifen, mit zwei nebeneinander liegenden Verbindungsbereichen, an denen die Metallstreifen mechanisch und elektrisch-galvanisch verbunden sind, und zwar bezüglich einer nicht zur Erfindung gehörenden Verbindung zwischen zwei Metallstreifen ohne zwischengefügter Isolierfolie;
- Figur 7a:: ein schematisch abgewandeltes, nicht zur Erfindung gehörendes Beispiel, bei dem die untere Platte entgegengesetzt zur Vertiefung in der Matrize vorverformt wurde;
- Figur 7b:: das Ergebnis der beiden verbundenen Platten in schematischer Querschnittsdarstellung bezüglich einer nicht zur Erfindung gehörenden Verbindung von zwei Platten ohne dazwischen befindliche Isolierfolie;
- Figur 8a:: ein zu Figur 7a nochmals abgewandeltes, nicht zur Erfindung gehörendes Beispiel, bei welchem beide Platten mit einer aufeinander zu weisenden Vorvertiefung versehen wurden;
- Figur 8b:: das Ergebnis der beiden mittels des Durchsetzfügewerkzeuges gemäß Figur 8a verbundenen, nicht zur Erfindung gehörenden Platten; und
- Figur 9a:: eine schematische Querschnittsdarstellung in einer Ausgangslage bezüglich eines Beispiels unter Erzeugung einer kapazitiven Verbindung zwischen zwei Platten, jedoch noch ohne Verwendung einer im Rahmen der Erfindung verwendeten vorgeprägten Platte, wie z.B. in Figur 2 gezeigt;
- Figur 9b:: die entsprechend hergestellte Verbindung zwischen der ersten und zweiten Platte unter Zwischenschaltung einer beide Platte isolierenden Isolierfolie, und zwar ohne Verwendung einer vorgeprägten Platte, wie sie in Figur 2 gezeigt ist;
- Figur 10a:: ein zu Figur 9a abgewandeltes erfindungsgemäßes Ausführungsbeispiel, bei welchem eine zwischengeschaltete Isolierfolie im Verbindungsbereich eine Ausnehmung aufweist; und
- Figur 10b:: die endgültig im Rahmen der Erfindung hergestellten verbundenen beiden Platten unter Zwischenschaltung einer Isolierfolie mit der anhand von Figur 10a gezeigten Ausnehmung im Verbindungsbereich.

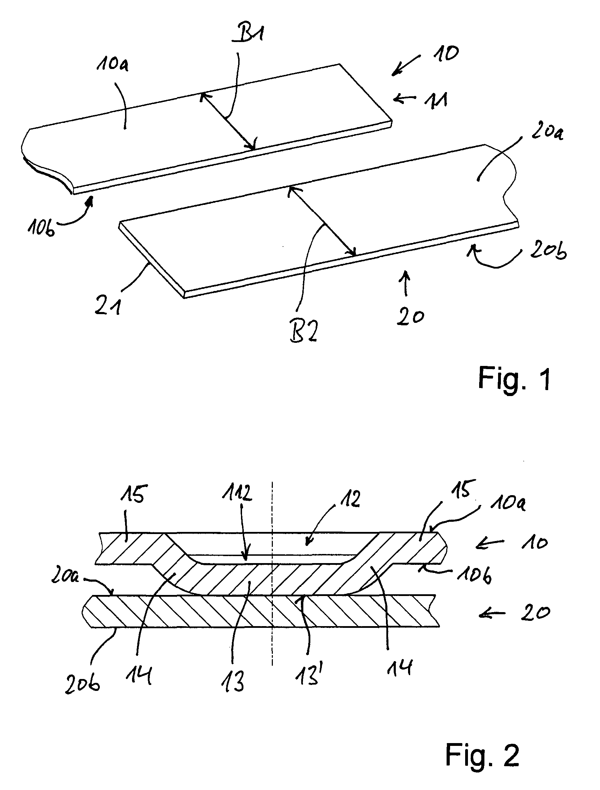

In Figur 1 ist in auszugsweiser schematischer Darstellung eine erste Platte 10 und eine zweite Platte 20 gezeigt, die mechanisch und elektrisch miteinander verbunden werden sollen. Da es sich hierbei um elektrisch leitende Platten handelt, in der Regel um metallische Platten oder metallisch plattenförmige Leiterbahnen, wird auch nachfolgend häufig von einer ersten und zweiten metallischen plattenförmigen Leiterbahn oder nur von einem ersten und zweiten metallischen plattenförmigen Leiterbahnabschnitt oder nur kurz von Leiterbahnabschnitten gesprochen.

Bei den in Rede stehenden Platten, also den vorstehend definierten Leiterbahnabschnitten handelt es sich von daher um elektrisch leitfähiges Material, beispielsweise Metallplatten die aus einem elektrisch leitfähigen Metall oder einer Legierung bestehen, vorzugsweise nur ein Material umfassen aber auch aus verschiedenen Materialien und/oder Schichten zusammen gesetzt sein können, und zwar mit oder ohne elektrisch leitfähige Oberflächenschichten und/oder Abschnitten.

Bei der gezeigten Ausführungsform handelt es sich um zwei nach Art von Metallblechen oder Metallstreifen gebildeter Platten 10 und 20, wobei die obere Platte 10 sich nach links weiter erstreckt und ein rechtsliegendes Ende 11 aufweist, wohingegen die untere zweite Platte 20 ein linksliegendes Ende 21 aufweist und sich nach rechts weiter erstreckt. Durch Verbindung einer derartigen ersten und zweiten Platte wird eine insgesamt längere Leitungsverbindung hergestellt (die beispielsweise aber auch als Dipol mit dieser Verbindungstechnik verwendet werden kann etc.). Bei den zu verbindenden Metallblechen oder Metallstreifen, Metallplatten etc. handelt es sich allgemein also um elektrisch leitfähige Körper und insbesondere Leitungsverbindungen, die beispielsweise auch als Dipole etc. eingesetzt werden können. Inhaltliche Beschränkungen sind durch die gewählte Begriffswahl nicht impliziert.

Mit dem Bezugszeichen 10a ist dabei die Oberseite und mit Bezugszeichen 10b die Unterseite der ersten Platte 10 bezeichnet. Mit dem Bezugszeichen 20a ist die Oberseite der zweiten Platte und mit 20b die Unterseite der zweiten Platte bezeichnet.

Im gezeigten Beispiel weist dabei die obere Platte eine geringere Breite B1 auf verglichen mit der Breite B2 der zweiten Platte 20. Dies ist aber nicht zwingend.

Obgleich im Zusammenhang mit dem Beispiel vor allem von den beiden Platten 10 und 20 gesprochen wird, geht es letztlich nur darum, dass zwei Plattenabschnitte 10 und 20, also zwei Leiterbahnabschnitte 10 und 20, im Rahmen der Erfindung mittels einer Fügeverbindung miteinander verbunden werden, wobei dann nicht verformte Plattenbereich 15 oder 25 zurückbleiben oder zurückbleiben können. Gleichwohl wird der Einfachheit halber nachfolgend vor allem von Platten 10 und 20 gesprochen, obgleich letztlich zwei mehr oder weniger in Parallellage zueinander bringbare Plattenabschnitte 10, 20, wie nachfolgend ausführlich erörtert, miteinander verbunden werden sollen.

Zum Verbinden der beiden Platten wird zunächst die obere Platte von ihrer plattenförmigen Ausgangsstellung gemäß Figur 2 verformt, und zwar durch Einbringung einer teller-, topf- oder schalenförmigen Vertiefung 12, die aber nicht zwangsläufig rotationssymmetrisch sein muss. Daher wird bevorzugt ein ebener Bodenbereich 13 mit einer Bodenunterseite 13' gebildet, die über seitlich ansteigende Flanken 14 in den eigentlichen verbleibenden unverformten Plattenbereich 15 übergeht. Bei der Vertiefung 12 handelt es sich insoweit um eine Vorprägung 112.

Dieser erste beispielsweise durch Prägen oder Verformen mittels eines geeigneten Presswerkzeuges durchgeführte Verfahrensschritt kann separat vorgenommen werden, um dann die so verformte erste Platte 1 entsprechend der Darstellung gemäß Figur 2 unter Auflage auf der darunter befindlichen noch unverformten zweiten Platte 20 zu bringen.

In dieser Situation kann nunmehr ein Durchsetzfügen, ein so genanntes Druckfügen (Toxen) durchgeführt werden, nämlich mittels eines geeigneten und nachfolgend noch erörterten Durchsetzfügewerkzeuges, welches einen Stempel und eine Matrize umfasst.

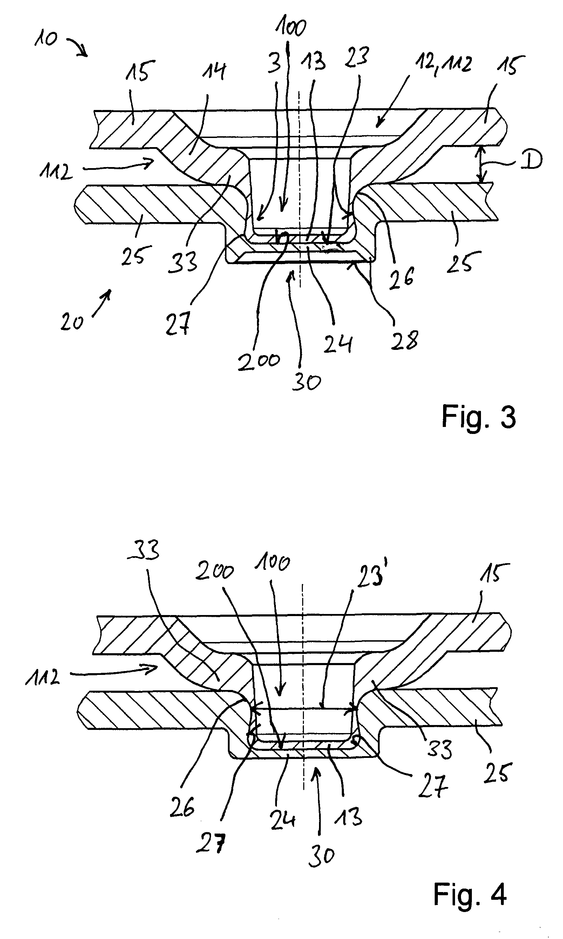

Das Ergebnis eines derartigen Durchsetzfügens ist in Querschnittsdarstellung in Figur 3 wiedergegeben, und zwar von seiner grundsätzlichen Funktionsweise, wobei in Figur 3 noch nicht ein erfindungsgemäßes Ausführungsbeispiel mit einer zwischen den Platten befindlichen Isolierfolie gezeigt ist.

Daraus ist zu ersehen, dass die untere Platte 20 in dem Verbindungsbereich 3 wie grundsätzlich bekannt eine topfförmige oder topfähnliche Vertiefung 200 aufweist, die im gezeigten Ausführungsbeispiel durch einen über die Unterseite 20b der zweiten Platte 20 nach unten hin überstehenden Bodenbereich 24 begrenzt ist. Der Innenraum 23 dieser topfförmigen Vertiefung 200 weist vor allem benachbart zum Bodenbereich 24 eine vorzugsweise umlaufende Hinterschneidung 27 auf. Dadurch ist das Größenmaß dieser topfförmigen Vertiefung 27 parallel zur Bodenplatte 24 in zumindest einer Erstreckungsrichtung oder in jeder beliebigen Erstreckungsrichtung größer als ein darüber befindlicher Innenraumabstand 23' (siehe Figur 4) . Wie aus der Darstellung gemäß Figur 3 oder 4 zu ersehen ist, wird während der Herstellung der Fügeverbindung im Bereich der teller- oder topfförmigen Vertiefung 12, also der entsprechend durchgeführten Vorprägung 112 im Bodenbereich 13 der Vorprägung eine weitere topfförmige Vertiefung 100 erzeugt, die innerhalb einer entsprechenden topfförmigen Vertiefung 200 in der zweiten Platte 20 zu liegen kommt. Da wie erwähnt die umlaufenden Seiten- oder Topfwände der topfförmigen Vertiefung 200 der zweiten Platte 20 mit einer Hinterschneidung vorzugsweise benachbart zum Bodenbereich 13 versehen ist, wird hier Material der ersten Platte in diese Hinterschneidung 27 während des Pressvorgangs unter Herstellung der Fügeverbindung eingepresst, wodurch eine feste Formschlussverbindung zwischen der ersten und der zweiten Platte realisiert wird.

Somit bildet also die erste Platte 10, das heißt also der erste Leiterbahnabschnitt 10 eine erste topfförmige oder topfähnliche Vertiefung 100, die in einer zweiten topfförmigen Vertiefung 200 der zweiten Platte 20, also in den zweiten Leiterbahnabschnitt 20 eingreift und in diesem Bereich unter Ausbildung einer Formschlussverbindung durch die dort vorgesehene Hinterschneidung 27 verpresst ist.

Durch die in der ersten Platte 10 zunächst eingebrachte Vorprägung 112 mit der Vertiefung 12 verbleibt in den endgültig miteinander verbundenen beiden Platten 10, 20 weiterhin ein Flanken- oder Schulterbereich 14 ausgebildet, der sich über den topfförmigen Öffnungsrand 26 der unteren zweiten Platte 20 nach oben hin weiter verlaufend erstreckt, so dass der unverformte Plattenbereich 15 der ersten Platte 10 in einem Abstand D parallel zu den verbleibenden unverformten Plattenbereich 25 der zweiten Platte 20 zu liegen kommt. Mit anderen Worten sind Materialbereiche, vor allem die Flanke oder Schulter 14 der ersten Platte 10 mit Bereichen des Öffnungsrandes 26 der zweiten Platte 20 verpresst, wodurch sich der in Figur 3 im Schnitt gezeigt leicht schräge und/oder wellige in Umfangsrichtung verlaufende Auflagen- und Verpressbereich 33 zwischen den beiden Plattenmaterialien ergibt.

Im gezeigten Beispiel weist die untere Platte 20 an der Unterseite der topfförmigen Vertiefung 200 noch ein nach unten überstehenden umlaufenden Rand 28 auf, der durch die Verwendung einer spezifischen Matrizenform entsteht und Vorteile beim Verpressen beider Plattenmaterialien zur Herstellung einer festen formschlüssigen Verbindung bietet. Dieser umlaufende untere Rand 28 muss aber nicht zwangsläufig vorgesehen sein, wie sich aus dem gemäß Figur 4 wiedergegebenen abgewandelten Beispiel ergibt.

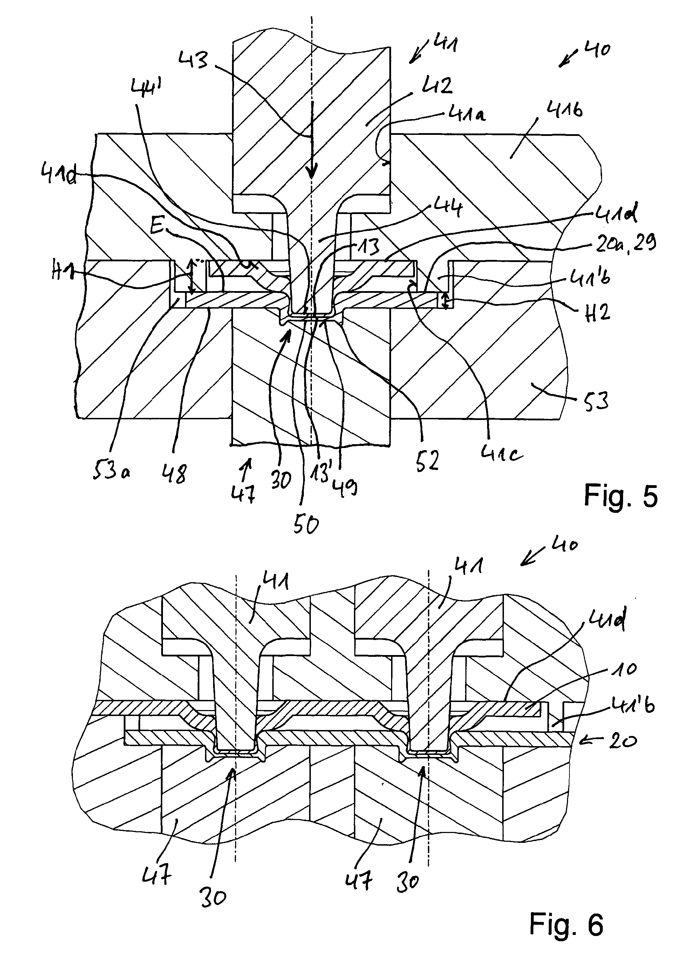

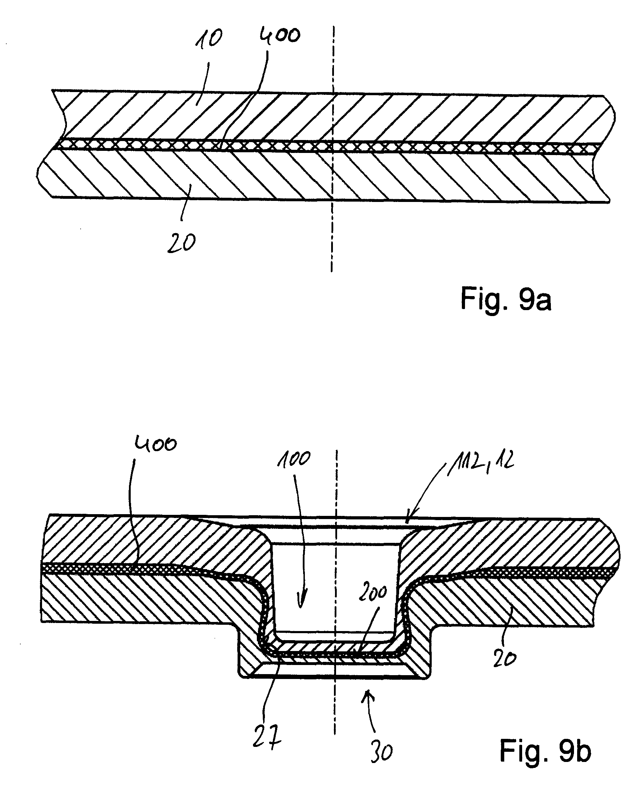

Nachfolgend wird auf ein Durchsetzfügewerkzeug gemäß Figur 5 Bezug genommen, mit dem auch die erfindungsgemäße Verbindung hergestellt werden kann, wie sie beispielsweise anhand von Figuren 9a ff beschrieben ist.

In Figur 5 ist in schematischer auszugsweiser Querschnittstellung ein Durchsetz-Fügewerkzeug 40 gezeigt, und zwar mit einem oben liegenden Formstempel 41 mit einem Trägerschaft 42, an dessen in Fügerichtung 43 liegenden Unterseite der eigentliche Arbeitsstempel 44 in axialer Verlängerung übersteht jedoch mit gegenüber dem Trägerschaft 42 deutlich geringerem Querdurchmesser.

Unterhalb der zu verbindenden Platten wird in dem Durchsetz-Fügewerkzeug 40 die Matrize 47 mit ebener oben liegender Auflagefläche 48 angeordnet, welche eine Vertiefung 49 beispielsweise nach Art einer Sackbohrung eingebracht ist.

Die Tiefzieh-Vertiefung 49 (die teilweise kurz nur als Vertiefung 49 bezeichnet wird) ist im gezeigten Beispiel - wenn eine rotationssymmetrische Verbindung zwischen der ersten und zweiten Platte hergestellt werden soll - topf- oder zylinderförmig gestaltet. Im gezeigten Beispiel weist die Vertiefung 49 am Übergang vom Boden 50 zur umlaufenden Begrenzungswand eine über die Fläche des Bodens 50 nach unten überstehende Umlaufende Ringnut 52 auf, wodurch die Verbindungstechnik noch verbessert werden kann, wie nachfolgend erläutert wird.

Im gezeigten Beispiel ist zudem die in Fügerichtung 43 vorlaufende Stirnwand 44' des Formstempels 41 eben und dabei parallel zu der Erstreckungsrichtung der ersten und zweiten Platte 10, 20 ausgerichtet. Der Formstempel 41 ist dabei in einer entsprechenden Ausnehmung 41a, d.h. in einem den Formstempel 41 aufnehmenden Stempelgehäuse 41b axial verschieblich gelagert.

Im gezeigten Beispiel ist das erwähnte Stempelgehäuse 41b mit einer unten liegenden Ausnehmung 41c versehen, die durch eine umlaufende in Fügerichtung 43 vorstehenden Gehäuseabschnitt 41'b in Umfangsrichtung begrenzt ist, die in Breitenrichtung zumindest so dimensioniert ist, dass die erste Platte 10 in entsprechender Breite aufgenommen ist. In Längsrichtung, also senkrecht zur Zeichenebene in Figur 4 ist die Ausnehmung 41c in einer solchen Länge gestaltet, dass die entsprechende erste Platte 10 gegebenenfalls aus dem Durchsetz-Fügewerkzeug 40 herausgeführt werden kann, zumindest an einer Seite, gegebenenfalls an beiden gegenüberliegenden Seiten, wenn beispielsweise die erste Platte in einem mittleren Bereich mit einer zweiten Platte verbunden werden soll.

Vor dem Verbinden der ersten und zweiten Platte 10, 20, also vor dem Verbinden des ersten und zweiten Leiterbahnabschnitts 10, 20, ist der erste Leiterbahnabschnitt 10 bereits in einem ersten Prägeschritt mit der anhand von Figur 2 erläuterten Vorprägung 112 mit der Vertiefung 12 versehen worden. Die Höhe H1 der Ausnehmung 41c entspricht dabei der Höhe der so vorverformten ersten Platte 10, derart, dass die unverformten Materialabschnitte, d.h. der unverformte Plattenbereich 15 mit seiner Oberseite 15a bevorzugt an der nach unten weisenden Rückhaltefläche 41d des Stempelgehäuses 41b anliegt.

Der zweite Leiterbahnabschnitt 20 liegt in einer entsprechenden Ausnehmung 53a in einem Matrizengehäuse 53, in welchem die Matrize 47 gehalten ist. Aus der Querschnittsdarstellung gemäß Figur 5 ist ersichtlich, dass dabei die Ausnehmung 53a eine größere Breite aufweist als die Breite der eigentlichen Matrize 47. Die Höhe H2 der Ausnehmung 53a entspricht dabei der Dicke der zweiten Platte 20.

Die Anordnung ist dabei derart, dass die Auflagefläche 29, also die Oberseite 20a der zweiten Platte und damit die unten liegende Begrenzungsfläche 13' des Bodenbereichs 13 der ersten Platte 10 vor dem abschließenden Herstellen der Fügeverbindung in einer Ebene oder einem ebenen Abschnitt E zu liegen kommen, die der Trennungsebene zwischen dem Stempelgehäuse 41b und dem Matrizengehäuse 53 im Bereich des umlaufenden Stempelgehäuseabschnittes 41'b entspricht. Dabei liegt ein Abschnitt 41'b des Stempelgehäuses 41b am Randbereich der zweiten Platte 20 auf deren Oberseite 20a auf.

Wird nunmehr zur Durchführung des Durchsetzfügens (Toxen) der oben liegenden Stempel in Fügerichtung 43 nach unten bewegt, wird ein mittlerer Bereich der topfförmigen Vertiefung 12 der ersten Platte 10 und der darunter befindliche Materialbereich der zweiten Platte 20 in die Vertiefung 49 der Matrize 47 ähnlich wie beim Tiefziehen unter plastischer Deformation eingedrückt, wodurch in Anbetracht der hohen Pressdrücke die entsprechenden Materialabschnitte fließfähig werden und dabei form- und kraftschlüssig miteinander und ineinander verbunden werden.

Vor allem die aufeinander liegenden Materialabschnitte der ersten und zweiten Platte 10, 20, die zwischen der in Fügerichtung nach unten weisenden Stirnwand 44' des Formstempels 41 und der Bodenfläche 50 in der Tiefziehöffnung 49 der Matrize 47 zu liegen kommen, werden dabei stark zusammen gepresst, so dass das Material der ersten und zweiten Platte radial nach außen gequetscht wird. Während des Pressvorgangs wird dabei die gesamte Sackbohrung, also die gesamte Vertiefung 49 zwischen dem Formstempel 41 und der Vertiefung 49 in der Matrize 47 ausgefüllt, so dass es hierbei gleichzeitig zu einer materialverfestigenden Verdichtung des Verformten Materials kommt. Aufgrund der Quetschwirkung wird dabei das Material der oben liegenden erste Platte 10 soweit radial verpresst und ausgedehnt, dass ein Teilbereich des Materials der ersten Platte hinter einer Tiefziehöffnung 23' der unteren Platte 20 gelangt, die eine Öffnungsgröße aufweist, die kleiner ist als die radiale Weite unterhalb der Tiefziehöffnung 23' benachbart zum Bodenbereich 24 in der Vertiefung 23 der zweiten Platte 20. In Figur 5 ist dabei die Situation am Ende des Herstellprozesses der Fügeverbindung gezeigt.

Mit anderen Worten wird zur Herstellung der gewünschten elektrischen Verbindung (d.h. der bis hierher besprochenen galvanischen Verbindung zwischen zwei plattenförmigen Elementen 10 und 20, also der Verbindung zwischen den beiden erwähnten metallischen plattenförmigen Leiterbahnabschnitten 10, 20) ein Durchsetz-Fügen ausgehend von zwei parallel zueinander verlaufenden Plattenabschnitten 10 und 20 beschrieben, bei denen übereinander liegende Flächenteile der Leiterbahnabschnitte 10, 20 miteinander in der erwähnten Tiefziehöffnung tiefgezogen und die tiefgezogenen Flächenteile unter Begrenzung der Ausdehnung in zwei einander abgewandten Querrichtungen und in Tiefziehrichtung breit gequetscht werden, wobei zum formschlüssigen Verhaken der Platten- oder Leiterbahnabschnitte 10, 20 ein tiefgezogener und quer gequetschter Flächenteil des oberen Plattenabschnitts 10 den untern Plattenabschnitt 20 hintergreift, so dass unter plastischer Verformung des Plattenmaterials des ersten und des zweiten Plattenabschnitts 10, 20 ein Fügeverbindungsbereich 30 entsteht, in welchem die beiden Plattenabschnitte 10, 20 form- und kraftschlüssig miteinander verbunden sind. Dadurch wird eine optimale mechanische Verbindung zwischen den beiden Plattenabschnitten und vor allem eine optimale elektrische-galvanische Verbindung geschaffen, die sehr intermodulationsarm ist und dies dauerhaft. Mit anderen Worten ist es im Rahmen der Erfindung möglich das Risiko des Auftretens von Intermodulationen sehr stark zu minimieren, so dass faktisch kaum oder kaum relevante Intermodulationen auftreten.

Zum Auswerfen des Werkstückes wird nunmehr der Stempel 41 entgegen der Fügerichtung 43 wieder zurückgefahren, wobei nunmehr das Stempelgehäuse 41b als Rückhalteeinrichtung dient, die die erste und zweite Platte in ihrer in Figur 5 gezeigten Stellung hält, auch wenn aufgrund der hohen Rückstellkräfte des Stempels 41 an sich Ziehkräfte auf die erste und zweite Platte während des Entformens eingeleitet werden.

Dabei wirkt also das Stempelgehäuse 41b als Rückhalteeinrichtung, nämlich mit einem Halteabschnitt 41d, an der der unverformte Plattenbereich 15 mit der ersten Platte 10 mit seiner Oberseite 15a anliegt, also entgegen der Fügerichtung beim Abziehen des Stempels nicht mitgenommen werden kann, und zwar ebenso wie ein unverformter Randbereich der zweiten Platte 20, dessen Oberfläche 20a an einem entsprechenden Anlageabschnitt 41'b des Stempelgehäuses 41b anliegt.

Nach dem Abziehen des Stempels 41 und dem Auseinanderfahren des Stempel- und des Matrizengehäuses 41b, 53 können die entsprechend mit dem Durchsetz-Fügeverfahren fest verbundenen Platten aus dem Werkzeug entnommen werden. Dazu kann beispielsweise die Matrize 47 entgegen des Matrizengehäuses 53 nach oben entgegengesetzt der Fügerichtung 43 um ein gewisses Maß angehoben werden, um die beiden miteinander verbundenen Platten 10, 20 aus dem gesamten Durchsetz-Fügewerkzeug 40 anzuheben und auszuwerfen. Die so fest mechanisch und elektrisch verbundenen Platten sind im Querschnitt aus Figur 3 bzw. 4 ersichtlich.

Da wie erwähnt in der Vertiefung 49 der Matrize 47 eine umlaufende Ringnut 52 unterhalb der Bodenfläche 50 eingebracht ist, ergibt sich grundsätzlich beim Verpressen die an Hand von Figur 3 gezeigte Querschnittsform mit dem nach unten überstehenden Rand 28 an der zweiten Platte 20. Würde in der Vertiefung 49 der Matrize 47 auf diese Ringnut 52 verzichtet werden, ergäbe sich eine Querschnittsform für die beiden miteinander verbundenen Platten, wie sie in Figur 4 wiedergegeben ist. Hier sind beliebige Abwandlungen weiterhin möglich, in Abhängigkeit der Querschnittsform der jeweiligen Vertiefung in der Matrize.

Da die so verbundenen Platten 10, 20 nur an ihrer betreffenden Verbindungsstelle, also ihren entsprechenden mittels des Durchsetzfügens verbundenen Bereiches 30 mechanisch und nur hier vor allem elektrisch verbunden sind, wird sichergestellt, dass keine Intermodulationen auftreten können. Zudem wird das Stehwellenverhältnis (VSWR) ebenfalls nicht verschlechtert, da die elektrische Verbindung nur im Bereich der mechanischen Verbindung realisiert ist und die beiden Platten 10, 20 ansonsten durch den Abstand D in ihrem nicht verformten Plattenbereich voneinander getrennt sind.

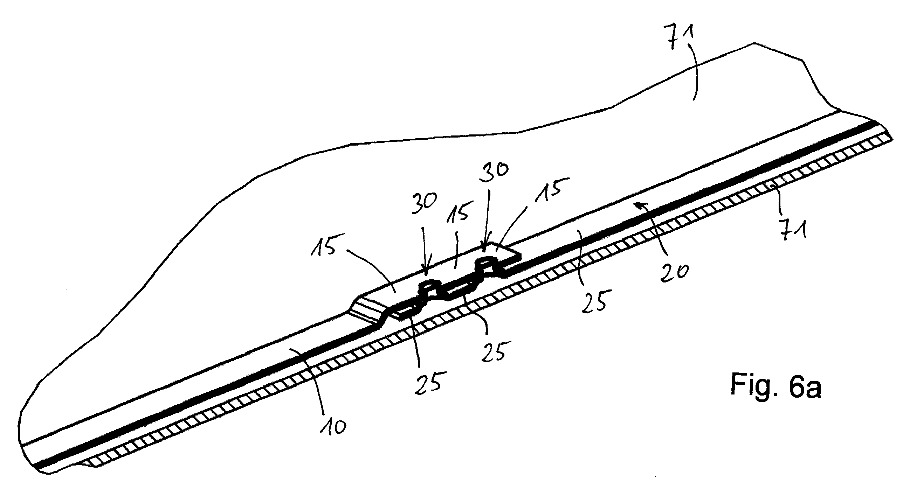

Anhand der schematischen Querschnittsdarstellung gemäß Figur 6 ist nur grundsätzlich dargestellt, dass beispielsweise das Durchsetz-Fügewerkzeug 40 zwei beabstandet voneinander vorgesehene Stempel und darunter zwei beabstandet voneinander vorgesehene Matrizen mit entsprechenden Vertiefungen aufweisen kann, so dass gegebenenfalls in einem gemeinsamen Schritt zwei voneinander beabstandete Verbindungsbereiche 30 erzeugt werden können, wodurch zwei Platten oder Plattenbleche oder Blechstreifen etc. elektrisch oder mechanisch gleichzeitig miteinander verbunden werden können, und zwar in einem Abstand D. Dadurch werden zwei Platten oder Streifen besonders fest miteinander verbunden, da mögliche Biegebeanspruchungen nicht allein nur auf eine Verbindungsstelle 30 einwirken können.

Anhand von Figur 6a ist dabei in schematischer perspektivischer Darstellung mit einem durch die Anordnung verlaufenden Längsschnitt gezeigt, wie zwei streifenförmige oder plattenförmige Platten oder Leiterbahnabschnitte 10, 20 in einem Überlappungsbereich an zwei versetzt zueinander liegenden Verbindungsstellen 30 fest mechanisch und elektrisch-galvanisch verbunden sind. Die gezeigte Anordnung ist dabei beispielsweise in einem Abstand vor einem leitfähigen Blech, beispielsweise ein Reflektorblech 71 angeordnet.

Schließlich wird auch angemerkt, dass nicht nur Platten, d.h. insbesondere Bleche oder blechförmige Streifen auf die geschilderte Weise miteinander mechanisch und elektrisch verbunden werden können, sondern dass im Rahmen der Erfindung beispielsweise auch elektrisch leitfähige Metallbleche oder Metallplatten beispielsweise an blechförmigen Gehäusewänden, an Reflektorblechen einer Mobilfunkantenne etc. angebracht werden können. Beschränkungen bestehen insoweit nicht.

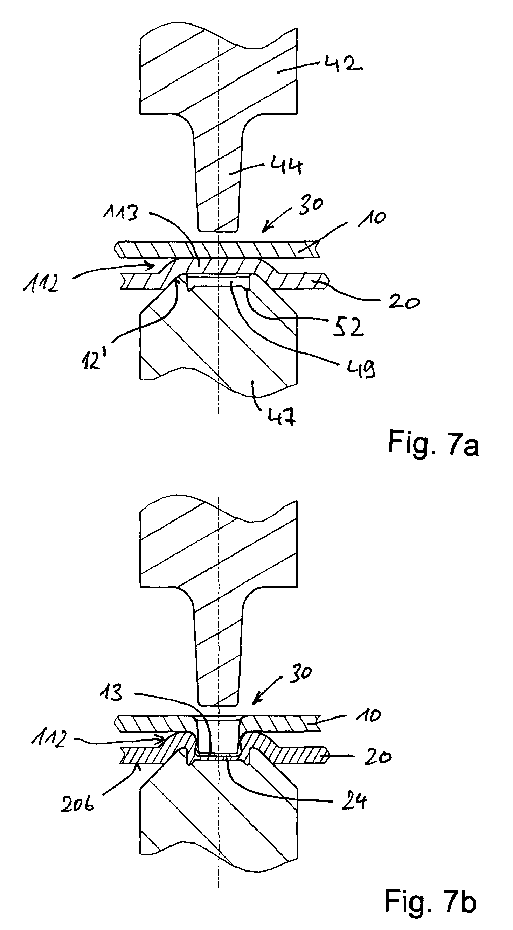

Anhand von Figur 7a ist eine Abwandlung insoweit gezeigt, als dort nicht die erste Platte 10 sondern die untere Platte 20 zunächst mit einer Vorprägung 112 mit einer topfförmigen Vertiefung 12' mit einem Bodenbereich 113, hier in Form einer auf die erste Platte 10 zulaufenden Vertiefung (hier im Sinne einer Erhebung) ausgestattet ist, wobei dann in einem zweiten Schritt mit einer entsprechend angepassten Matrize die Verformung durchgeführt wird.

Die Verbindungsstelle 30 ist dabei gleichermaßen ausgebildet, d.h. die beiden Platten bzw. Leiterbahnabschnitte 10 und 20 sind gleichermaßen fest miteinander verbunden, und zwar unter Herstellung einer optimalen elektrischen Verbindung. Nach Fertigstellung der Fügeverbindung (wie anhand von Figur 7b gezeigt) kommt dann die Unterseite des Bodens 24 eventuell in einer Höhe zu liegen, die nur geringfügig von dem Niveau der Unterseite 20b der zweiten Platte abweicht, d.h. geringfügig tiefer dazu liegt, auf gleicher Höhe des Niveaus der Unterseite 20b der zweiten Platte oder sogar oberhalb dieses Niveaus. Dies eröffnet die Möglichkeit, dass nach unten hin die Verbindungsstelle nicht über das Niveau der Platte 20, d.h. über das Niveau der Unterseitenfläche 20b übersteht. Das Beispiel gemäß Figur 7a und 7b unterscheidet sich von den Beispielen bis Figur 6 dadurch, dass die beiden ineinander greifenden topfförmigen Vertiefungen 100 und 200, wodurch die verpresste Formschlussverbindung erzielt wird, sich entgegengesetzt erstrecken zu der in umgekehrter Richtung in die zweite Platte 20 eingebrachte teller- oder topfförmige oder teller- oder topfähnliche Vertiefung 112.

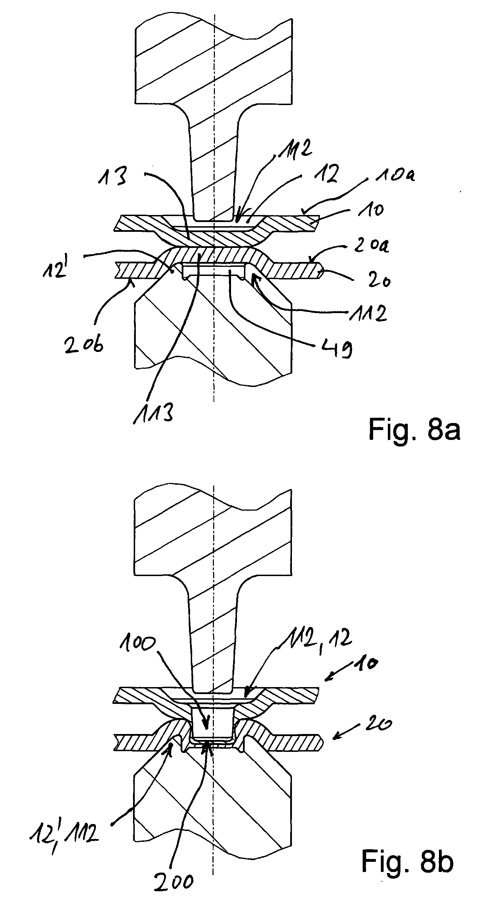

Anhand von Figur 8a und 8b ist das Entsprechende für den Fall gezeigt, dass die erste Platte 10 mit Vorprägung 112 mit einer topfförmigen Vertiefung 12 mit einem auf die zweite Platte 20 zu vorstehenden Bodenbereich und die zweite Platte mit einer entsprechenden Vorprägung 112 mit einer dazu entgegengesetzt ausgerichteten Vertiefung 12' mit einem auf die erste Platte 10 zu vorstehenden Bodenbereich 113 versehen wird (also mit ihrer Öffnung nach unten gerichtet), so dass bei Verwendung eines entsprechenden Stempelwerkzeuges und einer entsprechenden Matrize der Boden im Vertiefungsbereich der zweiten Platte ebenfalls wie vorstehend ausgeführt nicht so weit über die Unterseitenfläche 20b der zweiten Platte übersteht oder sogar vorher dazu endet. In all den Fällen greift eine erste topfförmige Vertiefung 100 der ersten Platte 10 in eine zweite topfförmige Vertiefung 200 der zweiten Platte 20, wobei die erste topfförmige Vertiefung mit ihrer umlaufenden Wandung oder zumindest Abschnitten davon in entsprechende Hinterschneidungen in der zweiten topfförmigen Vertiefung 200 der zweiten Platte 20 eingreift, um die gewünschte formschlüssige Verbindung zu erzielen.

Dies zeigt, dass beliebige Abwandlungen und Vorverformungen im Bereich der Verbindungsstelle 30 möglich sind, um eine Höhenlagenanpassung der Verbindung relativ zum Niveau der jeweiligen Platte zu schaffen. In allen Fällen ist es im Rahmen der Erfindung jedoch möglich, beide Platten in dem nichtverformten Plattenbereich in einem vordefinierten Abstand D zueinander zu halten, sich also hier sicherzustellen, dass keine elektrische Kontaktierung außerhalb des Verbindungsbereiches 30 stattfindet, wodurch die erfindungsgemäßen Vorteile realisiert werden.

Anhand von Figuren 9a und 9b soll eine erfindungsgemäße Lösung beschrieben werden, wobei die in den vorausgegangenen Beispielen erläuterten Funktionsweisen und Ausgestaltungen und die zur Herstellung beschriebenen Schritte auch bei den nachfolgend erörterten erfindungsgemäßen Ausführungsbeispielen grundsätzlich zum Tragen kommen.

Bei der Variante gemäß Figur 9a wird eine erste und eine zweite Platte 10, 20 im Rahmen des erläuterten Durchsetz-Fügeverfahrens miteinander verbunden. In Abweichung zu den vorausgegangenen Ausführungsbeispielen wird in diesem Falle allerdings weder die Platte 20 noch die Platte 20 mit einer Vorprägung 112 versehen. Beide Platten verlaufen auch in dem zu erzeugenden Verbindungsbereich 30 plan parallel zueinander. Die Anordnung ist sandwichartig, derart, dass zwischen der ersten und zweiten Platte bevorzugt eine dritte Materialschicht 400 vorgesehen bzw. zwischengefügt ist. Diese dritte Materialschicht 400 besteht aus einer elektrisch nicht leitfähigen Schicht, insbesondere einer Folie.

Die erwähnte Material- oder Zwischenschicht 400 kann aus einer flexiblen biegbaren Schicht bestehen, beispielsweise aus einer Folie, insbesondere einer isolierenden Folie. Die Dicke der Folie ist dabei auf bestimmte Dickenmaße nicht beschränkt, solange diese Materialschicht 400 gemeinsamt mit den plattenförmigen Abschnitten 10 und 20 mit verformt werden kann. Ebenso ist es nicht notwendig, dass diese Schicht 400, d.h. diese Material- und/oder Zwischenschicht 400 als separate Schicht 400 ausgebildet ist, beispielsweise nicht nur in Form einer Folie oder dergleichen sondern auch in Form einer Platte etc.. Ebenso möglich ist es nämlich, dass die zu verbindenden Platten oder Plattenabschnitte 10, 20 an ihrer aufeinander zuweisend liegenden Seite insbesondere zumindest in dem Kontaktbereich, in dem die Platten aneinander anliegen, mit einer isolierenden Schicht 400 überzogen ist. Dabei kann es sich beispielsweise um eine Lackschicht handeln, um eine auf- eloxierte Schicht, ein im Pulververfahren aufgetragene Schicht oder beispielsweise um eine mittels Walzen aufgetragenen Sicht. In diesem Fall wäre die Schicht also fest anhaftender Bestandteil zumindest einer Platte oder beider Platten, zumindest auf den aufeinander zu weisenden Plattenseiten. Weder vom Material noch von der Materialdicke oder Ausformung bestehen insoweit Einschränkungen. Soweit nachfolgend bezugnehmend auf diese isolierende Materialschicht 400 allgemein von Folie gesprochen wird, soll jedwede mögliche Ausbildung dieser Schicht gemeint sein.

Anschließend wird das Durchsetz-Fügeverfahren wie erläutert durchgeführt, wobei beispielsweise die erste Platte 10 in zwei aufeinander folgenden Schritten oder auch in einem ersten Schritt zunächst separat eine leichte Vorprägung im Sinne einer leichten tellerförmigen Vertiefung 112 erfährt.

Ansonsten wird wiederum durch einen geeigneten Stempel in der ersten Platte 10 eine topfförmige Vertiefung 100 erzeugt, deren topfförmig umlaufende Wand in eine entsprechende Hinterschneidung 27 der zweiten topfförmigen Verbindung 200 der zweiten Platte 20 eingreift. Auch im Verbindungsbereich 30 läuft die isolierende Folie 400 zwischen den beiden Platten hindurch, wobei durch die Herstellung der Durchsetz-Fügeverbindung in diesem Bereich die Foliendicke gegenüber ihrem sonstigen Bereich abnehmen kann, wie dies in Figur 9b angedeutet ist.

Wie bereits erwähnt betrifft die Darstellung gemäß Figuren 9a und 9b kein zur Erfindung gehörendes Ausführungsbeispiel. Ein erfindungsgemäßes Ausführungsbeispiel würde sich von den Figuren 9a und 9b dadurch unterscheiden, dass zumindest eine der beiden Leiterbahnabschnitte 10, 20 mit einer Vorprägung 112 versehen ist, durch die beispielsweise ein umlaufender Wulst oder eine umlaufende Flanke 14 ausgebildet wird, wie dies grundsätzlich anhand von Figur 2 gezeigt ist. Mit anderen Worten werden die beiden Leiterbahnabschnitte 10, 20 außerhalb des Verbindungsbereiches 30 auf Abstand gehalten. Dann wird, wie anhand von Figuren 9a und 9b gezeigt, im Verbindungsbereich die entsprechende Durchsetz-Fügeverbindung hergestellt, wobei die erwähnte isolierende Material- oder Zwischenschicht 400 über die Durchsetz-Fügeverbindung hinweg verläuft, und zwar unter Ausbildung der gewünschten kapazitiven Verbindung zwischen dem ersten und zweiten Leiterbahnabschnitt in dem Verbindungsbereich 30.

Dadurch wird eine kapazitive Kopplung oder Verbindung insbesondere für eine elektrische Hochfrequenz-Verbindung geschaffen. Dabei lässt sich das Fügeverfahren so abstimmen, dass insbesondere im Bereich der Verbindung 30 die gewünschte Größenordnung der kapazitiven Kopplung (Kondensator) erzielt wird.

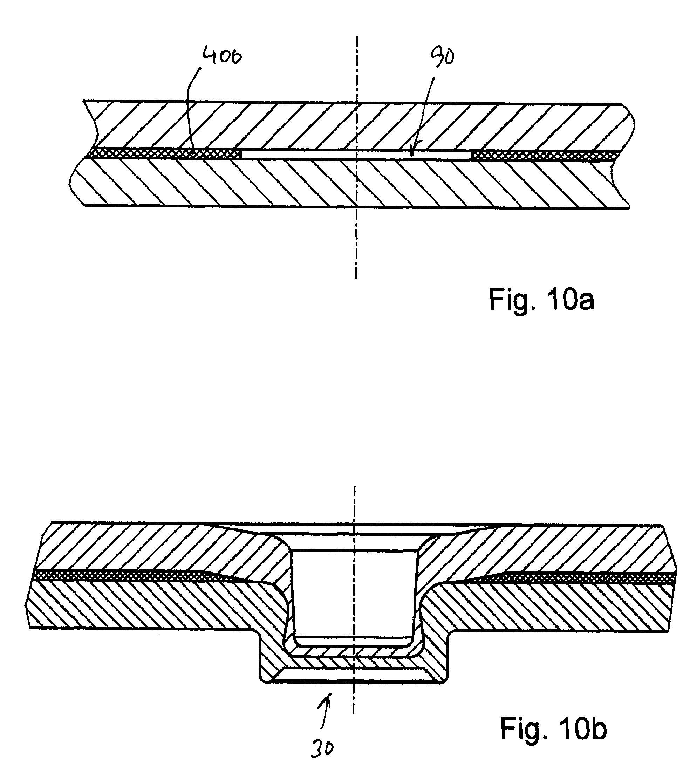

Schließlich wird anhand eines nochmals abgewandelten Ausführungsbeispiels gemäß den Figuren 10a und 10b gezeigt, dass eine galvanische Verbindung 30 im Rahmen des erläuterten Durchsetz-Fügeverfahrens ebenso erzeugt werden kann, wenn eine Folie 400 als Zwischenlage verwendet wird, ähnlich wie bei dem Ausführungsbeispiel gemäß Figur 9a und 9b. Allerdings soll diese Folie im Bereich der herzustellenden galvanischen Verbindung mit einer Ausnehmung oder einem Loch 90 versehen sein, wie dies in der Querschnittsdarstellung gemäß Figur 10 angedeutet ist. Anschließend wird das Durchsetz-Fügeverfahren wie anhand der anderen Ausführungsbeispiele erläutert durchgeführt. In diesem Falle wird eine optimale gewünschte galvanische Verbindung zwischen der ersten und zweiten Platte in dem Verbindungsbereich 30 realisiert, da hier die Folie 400 oder allgemein die separate oder mit einer Platte fest verbundene isolierende Material- oder Zwischenschicht 400 mit einer Ausnehmung 90 versehen war. Ansonsten wird bei dieser Variante von zwei plan parallelen Platten 10 und 20 ausgegangen, wobei zumindest eine Platte oder beide Platten (wie beispielsweise anhand von Figur 7a bis 8b erläutert) zunächst mit einer zumindest gering dimensionierten Vorprägung 112 in Form einer leichten teller- oder topfförmigen Vertiefung hergestellt werden kann, in dessen Bodenbereich dann die eigentliche topfförmige Vertiefung der ersten Platte 10 entsteht, die in die entsprechende Hinterschneidung 27 der topfförmigen Vertiefung 200 der zweiten Platte 20 im Verbindungsbereich (30) eingreift.

## Patentansprüche

1. Verfahren zur Herstellung einer elektrischen Verbindung zwischen zumindest zwei plattenförmigen metallischen Leiterbahnabschnitten (10, 20), mit folgenden Verfahrensschritten:
- die zumindest beiden galvanisch zu verbindenden Leiterbahnabschnitte (10, 20) werden zumindest in einem während des Herstellverfahrens unverformt bleibenden Plattenbereichs (15, 25) der Leiterbahnabschnitte (10, 20) im Abstand zueinander in Parallellage angeordnet,
- es wird eine isolierende Material- oder Zwischenschicht (400) verwendet, die zwischen den beiden zu verbindenden Leiterbahnabschnitten (10, 20) sandwichartig vorgesehen ist und die in einem Verbindungsbereich (30) einer herzustellenden Durchsetz-Fügeverbindung bereits vor deren Herstellung mit einer Ausnehmung (90) versehen wird, und
- die Durchsetz-Fügeverbindung zwischen den zumindest beiden Leiterbahnabschnitte (10, 20) wird durch die Ausnehmung (90) hindurch unter Erzeugung eines galvanischen Kontaktes zwischen den beiden Leiterbahnabschnitten (10, 20) hergestellt.

2. Verfahren nach Anspruch 1, **gekennzeichnet durch** die folgenden Merkmale:
- im Verbindungsbereich (30) wird in zumindest einem der zumindest beiden Leiterbahnabschnitte (10, 20) eine Vorprägung (112) mit einer Vertiefung (12, 12') derart eingebracht, dass ein **dadurch** ausgebildeter Bodenbereich (13, 113) versetzt zu dem unverformten Plattenbereich (15, 25) des Leiterbahnabschnitts (10, 20) zu liegen kommt, und
- die zumindest beiden Leiterbahnabschnitte (10, 20) werden so zueinander positioniert, dass der Bodenbereich (13, 113) des zumindest einen mit der Vorprägung (112) versehenen Leiterbahnabschnitts (10, 20) direkt in Anlage mit dem zweiten Leiterbahnabschnitt (20) gebracht wird, und dass in diesem Bereich die Durchsetz-Fügeverbindung hergestellt wird.

3. Verfahren nach Anspruch 2, **dadurch gekennzeichnet, dass** durch Einbringung der Vorprägung (112) unter Ausbildung der Vertiefung (12, 12') in zumindest einem der beiden Leiterbahnabschnitte (10, 20) im Bereich der Vertiefung (12, 12') ein umlaufender Wulst oder eine umlaufende Flanke (14) gebildet wird, und dass die zumindest beiden unverformten Plattenbereiche (15, 25) der beiden Leiterbahnabschnitte (10, 20) schon vor Herstellung der Durchsetz-Fügeverbindung durch den umlaufender Wulst oder die umlaufende Flanke (14) in einem Abstand (D) zueinander gehalten werden.

4. Verfahren zur Herstellung einer elektrischen Verbindung zwischen zumindest zwei plattenförmigen metallischen Leiterbahnabschnitten (10, 20), mit folgenden Verfahrensschritten:
- die zumindest beiden kapazitiv zu verbindenden Leiterbahnabschnitte (10, 20) werden zumindest in einem während des Herstellverfahrens unverformt bleibenden Plattenbereichs der Leiterbahnabschnitte (10, 20) im Abstand zueinander in Parallellage angeordnet,
- in einem Verbindungsbereich (30), in dem die zumindest beiden Leiterbahnabschnitte (10, 20) unter Verwendung eines Durchsetz-Fügewerkzeugs (40) unter Herstellung einer Durchsetz-Fügeverbindung miteinander verbunden werden, wird in zumindest einem der zumindest beiden Leiterbahnabschnitte (10, 20) eine Vorprägung (112) mit einer Vertiefung (12, 12') derart eingebracht, dass ein dadurch ausgebildeter Bodenbereich (13, 113) versetzt zu dem unverformten Plattenbereich (15, 25) des Leiterbahnabschnitts (10, 20) zu liegen kommt,
- es wird eine isolierende Material- oder Zwischenschicht (400) verwendet, die zwischen den beiden zu verbindenden Leiterbahnabschnitten (10, 20) angeordnet oder auf zumindest einer Seite eines Leiterbahnabschnitts (10, 20), der dem jeweils anderen damit zu verbindenden Leiterbahnabschnitt (10, 20) zugewandt liegt, zumindest in dem Verbindungsbereich (30) vorgesehen oder ausgebildet ist, und
- die zumindest beiden Leiterbahnabschnitte (10, 20) werden so zueinander positioniert, dass der Bodenbereich (13, 113) des zumindest einen mit der Vorprägung (112) versehenen Leiterbahnabschnitts (10, 20) unter Zwischenschaltung der isolierenden Material- oder Zwischenschicht (400) in Anlage mit dem zweiten Leiterbahnabschnitt (20) gebracht wird, und
- in diesem Bereich wird die Durchsetz-Fügeverbindung so hergestellt, dass die isolierende Material- oder Zwischenschicht (400) über die Durchsetz-Fügeverbindung hinweg verläuft, und zwar unter Ausbildung der kapazitiven Verbindung zwischen dem ersten und zweiten Leiterbahnabschnitt (10, 20) im Verbindungsbereich (30).

5. Verfahren nach Anspruch 4, **dadurch gekennzeichnet, dass** durch Einbringung der Vorprägung (112) unter Ausbildung der Vertiefung (12, 12') in zumindest einem der beiden Leiterbahnabschnitte (10, 20) im Bereich der Vertiefung (12, 12') ein umlaufender Wulst oder eine umlaufende Flanke (14) gebildet wird, wobei in dem Verbindungsbereich (30) die an dem zumindest einen Leiterbahnabschnitt (10, 20) so ausgebildete Vorprägung (12, 12') unter Zwischenschaltung einer isolierenden Material- oder Zwischenschicht (400) an dem anderen Leiterbahnabschnitt (20, 10) oder an der an dem anderen Leiterbahnabschnitt (20, 10) ausgebildeten weiteren Vorprägung (12, 12') anliegt, und dass die zumindest beiden unverformten Plattenbereiche (15, 25) der beiden Leiterbahnabschnitte (10, 20) schon vor Herstellung der Durchsetz-Fügeverbindung durch den umlaufender Wulst oder die umlaufende Flanke (14) in einem Abstand (D) zueinander gehalten werden.

6. Verfahren nach einem der Ansprüche 1 bis 5, **dadurch gekennzeichnet, dass** als isolierende Material- oder Zwischenschicht (400)
- eine verformbare Platte, oder
- eine Folie, oder
- eine auf zumindest einem der beiden zu verbindenden Leiterbahnabschnitte (10, 20) ausgebildete oder daran anhaftende Schicht, insbesondere in Form einer Lackschicht, einer aufeloxierten Schicht, einer aufgewalzten Schicht oder einer aufgeklebten Schicht verwendet wird.

7. Verfahren nach einem der Ansprüche 1 bis 6, **dadurch gekennzeichnet, dass** die Durchsetz-Fügeverbindung so hergestellt wird, dass der geschlossene Bodenbereich (13, 113) über die zum jeweils anderen Leiterbahnabschnitt (10, 20) abweisend liegende Ober- oder Unterseite (10a, 20b) des zugehörigen Leiterbahnabschnitts (10, 20) übersteht.

8. Verfahren nach einem der Ansprüche 1 bis 7, **dadurch gekennzeichnet, dass** die Durchsetz-Fügeverbindung so hergestellt wird, dass der geschlossene Bodenbereich (13, 113) in Höhe der Oberseite (10a) oder der Unterseite (20b) des zugehörigen Leiterbahnabschnitts (10, 20) liegt oder über die Oberseite (10a, 20b) des zugehörigen Leiterbahnabschnitts (10, 20) übersteht.

9. Verfahren nach einem der Ansprüche 1 bis 8, **dadurch gekennzeichnet, dass** eine Vorprägung (112) in einem ersten Schritt vor Durchführung der Herstellung der Durchsetz-Fügeverbindung oder gleichzeitig dazu in zumindest einen der beiden Leiterbahnabschnitte (10, 20) eingebracht wird.

10. Verfahren nach einem der Ansprüche 1 bis 9, **dadurch gekennzeichnet, dass** zumindest zwei oder mehrere Durchsetz-Fügeverbindungen zwischen zumindest zwei zu verbindenden Leiterbahnabschnitten (10, 20) gleichzeitig hergestellt werden, vorzugweise mit einem gemeinsamen Durchsetz-Fügewerkzeug (40).

11. Elektrische Verbindung, mit folgenden Merkmalen:
- die elektrische Verbindung in Form einer galvanischen Verbindung umfasst zumindest zwei plattenförmige metallische Leiterbahnabschnitte (10, 20),
- die zumindest beiden Leiterbahnabschnitte (10, 20) sind in einem Verbindungsbereich (30) mittels einer Durchsetz-Fügeverbindung miteinander verbunden,
- die zumindest beiden Leiterbahnabschnitte (10, 20) sind benachbart zur Durchsetz-Fügeverbindung auf Abstand zueinander angeordnet,
- zumindest benachbart zu der Durchsetz-Fügeverbindung ist zwischen den unverformten Plattenbereichen (15, 25) der Leiterbahnabschnitte (10, 20) eine isolierende Material- oder Zwischenschicht (400) sandwichartig vorgesehen,
- die zumindest in dem unverformten Plattenbereich (15, 25) zwischen den beiden Leiterbahnabschnitten (10, 20) vorgesehene isolierende Material- oder Zwischenschicht (400) ist in dem Verbindungsbereich (30) der Durchsetz-Fügeverbindung mit einer Ausnehmung (30) versehen, durch die hindurch die beiden Leiterbahnabschnitte (10, 20) mittels der Durchsetz-Fügeverbindung galvanisch kontaktiert sind.

12. Elektrische Verbindung nach Anspruch 11, **gekennzeichnet durch** die folgenden Merkmale:
- im Verbindungsbereich (30) ist in zumindest einem der zumindest beiden Leiterbahnabschnitte (10, 20) eine Vorprägung (112) mit einer Vertiefung (12, 12') derart eingebracht, dass ein **dadurch** ausgebildeter Bodenbereich (13, 113) versetzt zu dem unverformten Plattenbereich (15, 25) des Leiterbahnabschnitts (10, 20) liegt, und
- die zumindest beiden Leiterbahnabschnitte (10, 20) sind so zueinander positioniert, dass sich der Bodenbereich (13, 113) des zumindest einen mit der Vorprägung (112) versehenen Leiterbahnabschnitts (10, 20) direkt in Anlage mit dem zweiten Leiterbahnabschnitt (20) befindet, und dass in diesem verbindungsbereich die Durchsetz-Fügeverbindung vorgesehen ist.

13. Elektrische Verbindung nach Anspruch 12, **dadurch gekennzeichnet, dass** durch die Vorprägung (112) unter Ausbildung der Vertiefung (12, 12') in zumindest einem der beiden Leiterbahnabschnitte (10, 20) im Bereich der Vertiefung (12, 12') ein umlaufender Wulst oder eine umlaufende Flanke (14) gebildet ist, wobei in dem Verbindungsbereich (30) die an dem zumindest einen Leiterbahnabschnitt (10, 20) ausgebildete Vorprägung (12, 12') direkt an dem anderen Leiterbahnabschnitt (20, 10) oder an einer an dem anderen Leiterbahnabschnitt (20, 10) ausgebildeten weiteren Vorprägung (12, 12') anliegt, wodurch die beiden unverformten Plattenbereiche (15, 25) der beiden Leiterbahnabschnitte (10, 20) in einem Abstand (D) zueinander gehalten sind.

14. Elektrische Verbindung, mit folgenden Merkmalen:
- die elektrische Verbindung in Form einer kapazitiven Verbindung umfasst zumindest zwei plattenförmige metallische Leiterbahnabschnitte (10, 20)
- die zumindest beiden Leiterbahnabschnitte (10, 20) sind in einem Verbindungsbereich (30) mittels einer Durchsetz-Fügeverbindung miteinander verbunden,
- die zumindest beiden Leiterbahnabschnitte (10, 20) sind benachbart zur Durchsetz-Fügeverbindung auf Abstand zueinander gehalten oder angeordnet,
- in dem Verbindungsbereich (30) ist in zumindest einem der zumindest beiden Leiterbahnabschnitte (10, 20) eine Vorprägung (112) mit einer Vertiefung (12, 12') derart eingebracht, dass ein dadurch ausgebildeter Bodenbereich (13, 113) versetzt zu dem unverformten Plattenbereich (15, 25) des Leiterbahnabschnitts (10, 20) zu liegen kommt,
- eine isolierende Material- oder Zwischenschicht (400) ist zwischen den beiden zu verbindenden Leiterbahnabschnitten (10, 20) angeordnet oder auf zumindest einer Seite eines Leiterbahnabschnitts (10, 20), der dem jeweils anderen damit zu verbindenden Leiterbahnabschnitt (10, 20) zugewandt liegt, zumindest in dem Verbindungsbereich (30) vorgesehen,
- die zumindest beiden Leiterbahnabschnitte (10, 20) sind so zueinander positioniert, dass sich der Bodenbereich (13, 113) des zumindest einen mit der Vorprägung (112) versehenen Leiterbahnabschnitts (10, 20) unter Zwischenschaltung der isolierenden Material- oder Zwischenschicht (400) in Anlage mit dem zweiten Leiterbahnabschnitt (20) befindet, und
- die isolierende Material- oder Zwischenschicht (400) verläuft über die Durchsetz-Fügeverbindung hinweg, wodurch in diesem Verbindungsbereich (30) die kapazitive Verbindung zwischen dem ersten und zweiten Leiterbahnabschnitt (10, 20) ausgebildet ist.

15. Elektrische Verbindung nach Anspruch 14, **dadurch gekennzeichnet, dass** durch die Vorprägung (112) unter Ausbildung der Vertiefung (12, 12') in zumindest einem der beiden Leiterbahnabschnitte (10, 20) im Bereich der Vertiefung (12, 12') ein umlaufender Wulst oder eine umlaufende Flanke (14) gebildet ist, wobei in dem Verbindungsbereich (30) die an dem zumindest einen Leiterbahnabschnitt (10, 20) ausgebildete Vorprägung (12, 12') unter Zwischenschaltung der isolierenden Material- oder Zwischenschicht (400) an dem anderen Leiterbahnabschnitt (20, 10) oder an einer an dem anderen Leiterbahnabschnitt (20, 10) ausgebildeten weiteren Vorprägung (12, 12') anliegt, wodurch die beiden unverformten Plattenbereiche (15, 25) der beiden Leiterbahnabschnitte (10, 20) in einem Abstand (D) zueinander gehalten sind.

16. Elektrische Verbindung nach einem der Ansprüche 11 bis 15, **dadurch gekennzeichnet, dass** die isolierende Material- oder Zwischenschicht (400)
- aus einer verformbaren Platte, oder
- einer Folie, oder
- einer auf zumindest einem der beiden zu verbindenden Leiterbahnabschnitte (10, 20) ausgebildeten oder daran anhaftenden Schicht, insbesondere in Form einer Lackschicht, einer aufeloxierten Schicht, einer aufgewalzten Schicht oder einer aufgeklebten Schicht
besteht oder eine solche Schicht umfasst.

17. Elektrische Verbindung nach einem der Ansprüche 11 bis 16, **dadurch gekennzeichnet, dass** im Bereich der Durchsetz-Fügeverbindung (30) ein geschlossener Boden (13, 113) in dem zumindest einen Leiterbahnabschnitt (10, 20) ausgebildet ist, der über die Oberseite (10a, 20a) oder die Unterseite (10b, 20b) des zugehörigen Leiterbahnabschnitts (10, 20) übersteht oder in Höhe der Oberseite (10a, 20a) oder der Unterseite (10b, 20b) des zugehörigen Leiterbahnabschnitts (10, 20) liegt.

18. Elektrische Verbindung nach einem der Ansprüche 11 bis 17, **dadurch gekennzeichnet, dass** zumindest zwei oder mehrere Durchsetz-Fügeverbindungen zwischen zumindest zwei Leiterbahnabschnitten (10, 20) mit Seitenversatz zueinander ausgebildet sind.

## Claims

1. Method for producing an electrical connection between at least two plate-shaped metal conductor track portions (10, 20), comprising the following method steps:
- the at least two conductor track portions (10, 20) to be galvanically connected are arranged at a distance from one another in a parallel position, at least in a plate region (15, 25) of the conductor track portions (10, 20) which remains undeformed during the production process,
- an insulating material layer or intermediate layer (400) is used which is provided sandwiched between the two conductor track portions (10, 20) to be connected and is provided with a clearance (90) in a connection region (30) of a clinching connection to be produced before it is produced, and
- the clinching connection between the at least two conductor track portions (10, 20) is produced through the clearance (90) so as to produce a galvanic contact between the two conductor track portions (10, 20).

2. Method according to claim 1, **characterised by** the following features:
- an advance embossment (112) having a depression (12, 12') is formed in at least one of the at least two conductor track portions (10, 20) in the connection region (30), in such a way that a base region (13, 113) which is thus formed comes to be positioned offset from the undeformed plate region (15, 25) of the conductor track portions (10, 20), and
- the at least two conductor track portions (10, 20) are positioned with respect to one another in such a way that the base region (13, 113) of the at least one conductor track portion (10, 20) provided with the advance embossment (112) is brought into contact with the second conductor track portion (20) directly, and in that the clinching connection is produced in this region.

3. Method according to claim 2, **characterised in that**, by forming an advance embossment (112) so as to form a depression (12, 12') in at least one of the two conductor track portions (10, 20) in the region of the depression (12, 12') a peripheral flare or peripheral flank (14) is formed, and **in that** the at least two undeformed plate regions (15, 25) of the two conductor track portions (10, 20) are already held at a distance (D) from one another by the peripheral flare or the peripheral flank (14) before the clinching connection is produced.

4. Method for producing an electrical connection between at least two plate-shaped metal conductor track portions (10, 20), comprising the following method steps:
- the at least two conductor track portions (10, 20) to be capacitively connected are arranged at a distance from one another in a parallel position, at least in a plate region (15, 25) of the conductor track portions (10, 20) which remains undeformed during the production process,
- in a connection region (30), in which the at least two conductor track portions (10, 20) are interconnected using a clinching tool (40) so as to produce a clinching connection, an advance embossment (112) having a depression (12, 12') is formed in at least one of the at least two conductor track portions (10, 20), in such a way that a base region (13, 113) which is thus formed comes to be positioned offset from the undeformed plate region (15, 25) of the conductor track portion (10, 20),
- an insulating material layer or intermediate layer (400) is used and is arranged between the two conductor track portions (10, 20) to be connected or is provided or formed, at least in the connection region (30), on at least one side of a conductor track portion (10, 20) positioned facing the respective other conductor track portion (10, 20) to be connected thereto, and
- the at least two conductor track portions (10, 20) are positioned with respect to one another in such a way that the base region (13, 113) of the at least one conductor track portion (10, 20) provided with the advance embossment (112) is brought into contact with the second conductor track portion (20) with an insulating material layer or intermediate layer (400) interposed, and
- the clinching connection is produced in this region in such a way that the insulating material layer or intermediate layer (400) extends over the clinching connection, and specifically so as to form the capacitive connection between the first and second conductor track portion (10, 20) in the connection region (30).

5. Method according to claim 4 **characterised in that** by forming the advance embossment (112) so as to form the depression (12, 12') in at least one of the two conductor track portions (10, 20) in the region of the depression (12, 12') a peripheral flare or peripheral flank (14) is formed, the advance embossment (12, 12') thus formed on the at least one conductor track portion (10, 20) being positioned against the other conductor track portion (20, 10) or against the further advance embossment (12, 12') formed on the other conductor track portion (20, 10), with an insulating material layer or intermediate layer (400) interposed, in the connection region (30), and **in that** the at least two undeformed plate regions (15, 25) of the two conductor track portions (10, 20) are already held at a distance (D) from one another by the peripheral flare or the peripheral flank (14) before the clinching connection is produced.

6. Method according to any one of claims 1 to 5, **characterised in that**
- a deformable plate,
- a film, or
- a layer formed on or adhering to at least one of the two conductor track potions (10, 20) to be connected, in particular in the form of a lacquer layer, an anodised layer, a rolled-on layer or a glued-on layer
is used as the insulating material layer or intermediate layer (400).

7. Method according to any one of claims 1 to 6 **characterised in that** the clinching connection is produced in such a way that the closed base region (13, 113) projects beyond the upper side or underside (10a, 20b) of the associated conductor track (10, 20) positioned facing away from the respective other conductor track portion (10, 20).

8. Method according to any one of claims 1 to 7, **characterised in that** the clinching connection is produced in such a way that the closed base region (13, 113) is positioned at the height of the upper side (10a) or underside (20b) of the associated conductor track portion (10, 20) or projects beyond the upper side (10a, 20b) of the associated conductor track potion (10, 20).

9. Method according to any one of claims 1 to 8, **characterised in that** an advance embossment (112) is formed in at least one of the two conductor track portions (10, 20) in a first step before producing the clinching connection or simultaneously with this.

10. Method according to any one of claims 1 to 9, **characterised in that** at least two or more clinching connections are simultaneously produced between at least two conductor track portions (10, 20) to be connected, preferably using a shared clinching tool (40).

11. Electrical connection having the following features:
- the electrical connection in the form of a galvanic connection comprises at least two plate-shaped metal conductor track portions (10, 20),
- the at least two conductor track portions (10, 20) are interconnected by means of a clinching connection in a connection region (30),
- the at least two conductor track portions (10, 20) are arranged at a distance from one another adjacent to the clinching connection,
- an insulating material layer or intermediate layer (400) is provided sandwiched between the undeformed plate regions (15, 25) of the conductor track portions (10, 20), at least adjacent to the clinching connection,
- the insulating material layer or intermediate layer (400), provided at least in the undeformed plate region (15, 25) between the two conductor track portions (10, 20), is provided with a clearance (30) in the connection region (30) of the clinching connection, through which the two conductor track portions (10, 20) are galvanically contacted via the clinching connection.

12. Electrical connection according to claim 11, **characterised by** the following features:
- an advance embossment (112) having a depression (12, 12') is formed in at least one of the at least two conductor track portions (10, 20) in the connection region (30), in such a way that a base region (13, 113) which is formed thereby is positioned offset from the undeformed plate region (15, 25) of the conductor track portions (10, 20), and
- the at least two conductor track portions (10, 20) are positioned with respect to one another in such a way that the base region (13, 113) of the at least one conductor track portion (10, 20) provided with the advance embossment (112) is in contact with the second conductor track portion (20) directly, and in that the clinching connection is provided in this connection region.

13. Electrical connection according to claim 12, **characterised in that** by forming the advance embossment (112) so as to form a depression (12, 12') in at least one of the two conductor track portions (10, 20) in the region of the depression (12, 12') a peripheral flare or peripheral flank (14) is formed, the advance embossment (12, 12') formed on the at least one conductor track portion (10, 20) being positioned in the connection region (30) directly against the other conductor track portion (20, 10) or against the further advance embossment (12, 12') formed on the other conductor track portion (20, 10), whereby the two undeformed plate regions (15, 25) of the two conductor track portions (10, 20) are held at a distance (D) from one another.

14. Electrical connection having the following features:
- the electrical connection in the form of a capacitive connection comprises at least two plate-shaped metal conductor track portions (10, 20),
- the at least two conductor track portions (10, 20) are interconnected by means of a clinching connection in a connection region (30),
- the at least two conductor track portions (10, 20) are arranged at a distance from one another adjacent to the clinching connection,
- an advance embossment (112) having a depression (12, 12') is formed in at least one of the at least two conductor track portions (10, 20) in the connection region (30), in such a way that a base region (13, 113) which is formed thereby comes to be positioned offset from the undeformed plate region (15, 25) of the conductor track portions (10, 20),
- an insulating material layer or intermediate layer (400) is arranged between the two conductor track portions (10, 20) to be connected or is provided, at least in the connection region (30), on at least one side of a conductor track portion (10, 20) positioned facing the respective other conductor track portion (10, 20) to be connected thereto,
- the at least two conductor track portions (10, 20) are positioned with respect to one another in such a way that the base region (13, 113) of the at least one conductor track portion (10, 20) provided with the advance embossment (112) is in contact with the second conductor track portion (20) with the insulating material layer or intermediate layer (400) interposed, and
- the insulating material layer or intermediate layer (400) extends over the clinching connection, whereby the capacitive connection between the first and second conductor track portion (10, 20) is formed in said connection region (30).

15. Electrical connection according to claim 14, **characterised in that** by forming the advance embossment (112) so as to form the depression (12, 12') in at least one or the two conductor track portions (10, 20) in the region of the depression (12, 12') a peripheral flare or peripheral flank (14) is formed, the advance embossment (12, 12') formed on the at least one conductor track portion (10, 20) being positioned in the connection region (30) against the other conductor track portion (20, 10) or against the further advance embossment (12, 12') formed on the other conductor track portion (20, 10), whereby the two undeformed plate regions (15, 25) of the two conductor track portions (10, 20) are held at a distance (D) from one another.

16. Electrical connection according to any one of claims 11 to 15, **characterised in that** the insulating material layer or intermediate layer (400) consists of or comprises
- a deformable plate,
- a film, or
- a layer formed on or adhering to at least one of the two conductor track potions (10, 20) to be connected, in particular in the form of a lacquer layer, an anodised layer, a rolled-on layer or a glued-on layer.

17. Electrical connection according to any one of claims 11 to 16, **characterised in that** a closed base (13, 113) is formed in the at least one conductor track portion (10, 20) in the region of the clinching connection (30), and projects beyond the upper side (10a) or underside (20b) of the associated conductor track portion (10, 20) or is positioned at the height of the upper side (10a, 20a) or underside (10b, 20b) of the associated conductor track portion (10, 20).

18. Electrical connection according to any one of claims 11 to 17, **characterised in that** at least two or more clinching connections are formed between at least two conductor track portions (10, 20) with a mutual lateral offset.

## Revendications

1. Procédé de réalisation d'une liaison électrique entre au moins deux segments conducteurs (10, 20) en forme de plaques métalliques avec les étapes de procédé suivantes :
- les au moins deux segments conducteurs (10, 20) à relier de manière galvanique sont disposés en position parallèle avec un espace entre eux au moins dans une région de plaque (15, 25) restant non déformée des segments conducteurs (10, 20) pendant le procédé de réalisation,
- on emploie une couche de matériau isolant ou intermédiaire (400), qui est prévue sous forme d'un sandwich entre les deux segments conducteurs (10, 20) à relier, et qui est munie d'un évidement (90), dans une région de liaison (30) d'une liaison par interpénétration, déjà avant sa réalisation, et
- la liaison par interpénétration entre les au moins deux segments conducteurs (10, 20) est réalisée par le passage à travers l'évidement (90) entre les deux segments conducteurs (10, 20).

2. Procédé selon la revendication 1, **caractérisé par** les propriétés suivantes :
- dans la zone de liaison (30), une prédécoupe (112) avec une cavité (12, 12') est rapportée dans au moins l'un des au moins deux segments conducteurs (10, 20) de telle manière qu'une région de socle (13, 113) ainsi formée arrive à être décalée par rapport à la région de plaque (15, 25) du segment conducteur (10, 20) et
- les au moins deux segments conducteur (10, 20) sont positionnés l'un par rapport à l'autre de sorte que la région de socle (13, 113) de l'au moins un segment conducteur (10, 20) muni de la prédécoupe (112) est rapportée directement en contact avec le second segment conducteur (20), et que la liaison par interpénétration est réalisée dans cette région.

3. Procédé selon la revendication 2, **caractérisé en ce que**, par la mise en place de la prédécoupe (112) avec la formation de la cavité (12, 12') dans au moins un des deux segments conducteurs (10, 20), il se forme un bourrelet périphérique ou un épaulement (14) périphérique dans la région de la cavité (12, 12'), et que les au moins deux régions de plaque (15, 25) non déformées des deux segments conducteurs (10, 20) sont maintenues à une distance (D) l'une par rapport à l'autre par le bourrelet périphérique ou l'épaulement (14) périphérique déjà avant la réalisation de la liaison par interpénétration.

4. Procédé de réalisation d'une liaison électrique entre au moins deux segments conducteurs (10, 20) en forme de plaques métalliques, avec les étapes de procédé suivantes :
- les au moins deux segments conducteurs (10, 20) à relier de manière capacitive sont disposés en position parallèle à distance l'un par rapport à l'autre dans au moins une région de plaque des segments conducteurs (10, 20) restant non déformée pendant le procédé de réalisation,
- dans une région de liaison (30), dans laquelle les au moins deux segments conducteurs (10, 20) ont été reliés ensemble moyennant l'utilisation d'un outil d'assemblage par interpénétration (40), avec la création d'une liaison par interpénétration, une prédécoupe (112) avec une cavité (12, 12') est rapportée dans au moins l'un des au moins deux segments conducteurs (10, 20) de telle manière que la région de socle (13, 113) ainsi formée arrive à être décalée par rapport à une région de plaque (15, 25) non déformée du segment conducteur (10, 20),
- une couche de matériau isolant ou intermédiaire (400) est employée, qui est disposée entre les deux segments conducteurs (10, 20) à relier ou se situe orientée sur au moins un côté d'un segment conducteur (10, 20) qui est respectivement disposé orienté vers l'autre segment conducteur (10, 20) à relier avec lui, est au moins prévue ou conçue dans la région de liaison (30), et
- les au moins deux segments conducteurs (10, 20) sont positionnés l'un par rapport à l'autre de telle manière que la région de socle (13, 113) de l'au moins un segment conducteur (10, 20) muni avec une prédécoupe (112) est apportée en contact avec le second segment conducteur (20) moyennant un branchement intermédiaire de la couche de matériau isolant ou intermédiaire (400), et
- dans cette région, la liaison par interpénétration est ainsi réalisée que la couche de matériau isolant ou intermédiaire (400) s'étend au-delà de la liaison par interpénétration, et particulièrement, avec la formation de la liaison capacitive, entre les premier et second segments conducteurs (10, 20) dans la région de liaison (30).

5. Procédé selon la revendication 4, **caractérisé en ce que**, par la mise en place d'une prédécoupe (112) moyennant la formation de la cavité (12, 12') dans au moins l'un des deux segments conducteurs (10, 20), un bourrelet périphérique ou un épaulement (14) périphérique est formé dans la région de la cavité (12, 12'), où, dans la région de liaison (30), la prédécoupe (12, 12') ainsi formée sur l'au moins un segment conducteur (10, 20) est en contact, moyennant un branchement intermédiaire d'une couche de matériau isolant ou intermédiaire (400), sur l'autre segment conducteur (20, 10) ou est en contact avec une autre prédécoupe (12, 12') formée sur l'autre segment conducteur (20, 10), et que les au moins deux régions de plaque (15, 25) non déformées des deux segments conducteurs (10, 20) sont maintenues l'une par rapport à l'autre à une distance (D) déjà avant la réalisation de la liaison par interpénétration par le bourrelet périphérique ou l'épaulement (14) périphérique.

6. Procédé selon l'une des revendications 1 à 5, **caractérisé en ce qu'**en tant que couche de matériau isolant ou intermédiaire (400) on emploie
- une plaque déformable, ou
- un film, ou
- une couche formée sur au moins l'un des deux segments conducteurs (10, 20) à relier, ou une couche y adhérant, notamment sous la forme d'une couche de laque, d'une couche anodisée en surface, d'une couche laminée en surface ou d'une couche collée en surface.

7. Procédé selon l'une des revendications 1 à 6, **caractérisé en ce que** la liaison par interpénétration est réalisée de telle manière que la région de socle (13, 113) fermée dépasse au dessus du segment conducteur (10, 20) correspondant sur la face supérieure ou inférieure (10a, 20b) respective de l'autre segment conducteur (10, 20) rebutant.

8. Procédé selon l'une des revendications 1 à 7, **caractérisé en ce que** la liaison par interpénétration est réalisée de telle manière que la région de socle (13, 113) fermée se situe à la hauteur de la face supérieure (10a) ou de la face inférieure (20b) du segment conducteur (10, 20) correspondant ou dépasse par-dessus la face supérieure (10a, 20b) du segment conducteur (10, 20) correspondant.

9. Procédé selon l'une des revendications 1 à 8, **caractérisé en ce qu'**une prédécoupe (112) est mise en place dans une première étape pour l'exécution de la réalisation de la liaison par interpénétration ou simultanément à celle-ci dans au moins un des deux segments conducteurs (10, 20).

10. Procédé selon l'une des revendications 1 à 9, **caractérisé en ce qu'**au moins deux ou plusieurs liaisons par interpénétration sont réalisées simultanément entre au moins deux segments conducteurs (10, 20) à relier, de préférence avec un outil d'assemblage par interpénétration (40) commun.

11. Liaison électrique, avec les caractéristiques suivantes :
- la liaison électrique sous la forme d'une liaison galvanique comprend au moins deux segments conducteurs (10, 20) en forme de plaques métalliques,
- les au moins deux segments conducteurs (10, 20) sont reliés ensemble dans une région de liaison (30) au moyen d'une liaison par interpénétration,
- les au moins deux segments conducteurs (10, 20) sont disposés avec une distance entre eux au voisinage de la liaison par interpénétration,
- une couche de matériau isolant ou intermédiaire (400) de type sandwich est prévue au moins au voisinage de la liaison par interpénétration entre les régions de plaques (15, 25) non déformées des segments conducteurs (10, 20),
- l'au moins une couche de matériau isolant ou intermédiaire (400), prévue entre les deux segments conducteurs (10, 20) dans au moins la région de plaque non déformée (15, 25), est munie d'un évidement (30) dans la région de liaison (30) de la liaison par interpénétration, par lequel les deux segments conducteurs (10, 20) sont en contact galvanique au moyen de la liaison par interpénétration.

12. Liaison électrique selon la revendication 11, **caractérisée par** les caractéristiques suivantes :
- dans la région de liaison (30), au moins une prédécoupe (112) avec une cavité (12, 12') est rapportée dans au moins l'un des deux segments conducteurs (10, 20) de telle manière que la région de socle (13, 113) ainsi formée se situe décalée par rapport à une région de plaque (15, 25) non déformée du segment conducteur (10, 20), et
- les au moins deux segments conducteurs (10, 20) sont positionnés l'un par rapport à l'autre de telle manière que la région de socle (13, 113) de l'au moins un segment conducteur (10, 20) muni d'une prédécoupe (112) se trouve directement en contact avec le second segment conducteur (20) et que, dans cette région de liaison, la liaison par interpénétration est prévue.

13. Liaison électrique selon la revendication 12, **caractérisée en ce que**, par la prédécoupe (112) avec la formation de la cavité (12, 12') dans au moins l'un des deux segments conducteurs (10, 20), un bourrelet périphérique, ou un épaulement (14) périphérique, est formé dans la région de la cavité (12, 12'), où, dans la région de liaison (30), la prédécoupe (12, 12') formée sur au moins un segment conducteur (10, 20) est directement en contact sur l'autre segment conducteur (20, 10) ou sur une autre découpe (12, 12') formée sur l'autre segment conducteur (20, 10), ce par quoi les deux régions de plaque (15, 25) non déformées des deux segments conducteurs (10, 20) sont maintenues avec une distance (D) entre elles.

14. Liaison électrique, avec les caractéristiques suivantes :
- la liaison électrique sous la forme d'une liaison capacitive comprend au moins deux segments conducteurs (10, 20) en forme de plaques métalliques,
- les au moins deux segments conducteurs (10, 20) sont reliés ensemble dans une région de liaison (30) au moyen d'une liaison par interpénétration,
- les au moins deux segments conducteurs (10, 20) sont maintenus avec une distance entre eux ou disposés au voisinage de la liaison par interpénétration,
- dans la région de liaison (30), dans au moins l'un des deux segments conducteurs (10, 20), au moins une prédécoupe (112) avec une cavité (12, 12') est rapportée de telle manière que la région de socle (13, 113) ainsi formée arrive à être décalée par rapport à une région de plaque (15, 25) non déformée du segment conducteur (10, 20),
- une couche de matériau isolant ou intermédiaire (400) est disposée entre les deux segments conducteurs (10, 20) ou au moins est prévue sur au moins un côté d'un segment conducteur (10, 20), qui se situe orienté respectivement vers l'autre segment conducteur (10, 20) relié avec celui-ci, au moins dans la région de liaison (30),
- les au moins deux segments conducteurs (10, 20) sont positionnés l'un par rapport à l'autre de telle manière que la région de socle (13, 113) de l'au moins un segment conducteur (10, 20) muni avec une prédécoupe (112) se trouve en contact avec le second segment conducteur (20) moyennant la connexion intermédiaire de la couche de matériau isolant ou intermédiaire (400), et
- la couche de matériau isolant ou intermédiaire (400) s'étend au-delà de la liaison par interpénétration, ce par quoi, dans cette région de liaison (30), la liaison capacitive entre les premier et second segments conducteurs (10, 20) est formée.

15. Liaison électrique selon la revendication 14, **caractérisée en ce que**, par la prédécoupe (112) avec la formation de la cavité (12, 12') dans au moins l'un des deux segments conducteurs (10, 20), un bourrelet périphérique ou un épaulement (14) périphérique est formé dans la région de la cavité (12, 12'), où, dans la région de la liaison (30), la prédécoupe (12, 12') sur l'au moins un segment conducteur (10, 20), moyennant une connexion intermédiaire de la couche de matériau isolant ou intermédiaire (400), est en contact sur l'autre segment conducteur (20, 10) ou une autre prédécoupe (12, 12') formée sur l'autre segment conducteur (20, 10), ce par quoi les deux zones de plaques (15, 25) non déformées des deux segments conducteurs (10, 20) sont maintenues à une distance (D) entre elles.

16. Liaison électrique selon l'une des revendications 11 à 15, **caractérisée en ce que** la couche de matériau isolant ou intermédiaire (400) est constituée
- d'une plaque déformable, ou
- d'un film, ou
- d'une couche formée sur au moins l'un des deux segments conducteurs (10, 20), ou y adhérant, notamment sous la forme d'une couche de laque, d'une couche d'anodisation en surface, d'une couche laminée en surface ou d'une couche collée en surface, ou comprend une telle couche.

17. Liaison électrique selon l'une des revendications 11 à 16, **caractérisée en ce que**, dans la région de la liaison par interpénétration (30), un socle fermé (13, 113) est formé dans au moins un segment conducteur (10, 20), qui dépasse de la face supérieure (10a, 20a) ou de la face inférieure (10b, 20b) du segment conducteur (10, 20) correspondant ou se situe à hauteur de la face supérieure (10a, 20a) ou de la face inférieure (10b, 20b) du segment conducteur (10, 20) correspondant.

18. Liaison électrique selon l'une des revendications 11 à 17, **caractérisée en ce qu'**au moins deux ou plusieurs liaisons par interpénétration sont formées entre au moins deux segments conducteurs (10, 20) avec un écart latéral entre elles.
